# EUROPEAN PATENT APPLICATION

(11) **EP 4 626 177 A1**
(43) Date of publication of application: **01.10.2025**
(21) Application number: 25157290.5
(22) Date of filing: 12.02.2025
(51) Int. Cl.: H10D 84/01, H10D 84/83

(54) **ZERO DIFFUSION BREAK FOR IMPROVING TRANSISTOR DENSITY**

(30) Priority: 29.03.2024 US 202418622122
(71) Applicant: INTEL Corporation, Santa Clara, CA 95054 (US)
(72) Inventor: YEUNG, Chun Wing, Portland, 97229 (US); CHU, Tao, Portland, 97229 (US); XU, Guowei, Portland, 97229 (US); HUANG, Chiao-Ti, Portland, 97229 (US); CHAO, Robin, Portland, 97209 (US); ZHANG, Feng, Portland, 97229 (US); HUNG, Ting-Hsiang, Beaverton, 97007 (US); LIN, Chia-Ching, Portland, 97229 (US); ZHANG, Yang, Rio Rancho, 87124 (US); ZHANG, Kan, Hillsboro, 97123 (US); JANG, Minwoo, Portland, 97229 (US); LUO, Yanbin, Portland, 97229 (US); PACKAN, Paul, Hillsboro, 97124 (US); LIN, Chung-Hsun, Portand, 97229 (US); MURTHY, Anand, Portland, 97229 (US)
(74) Representative: Goddar, Heinz J.

(57) **Abstract**

Isolation breaks between logic cells in integrated circuit (IC) devices. A source-drain trench between adjacent channel regions includes a pair of source or drain semiconductor bodies, a first of the source or drain bodies in the source-drain trench is connected to a first of the channel regions, a second of the source or drain bodies in the source-drain trench is connected to a second of the channel regions, and a dielectric isolation is in the source-drain trench and between the pair of source or drain bodies. The dielectric isolation may include a void between layers or sidewalls of dielectric. The pair of source or drain bodies may include highly conductive, metallized layers in contact with the dielectric isolation.

## Description

### BACKGROUND

While vast resources are spent to scale down transistor feature sizes and so increase device density, significant portions of layout area are consumed by diffusion breaks to separate logic cells, i.e., between devices at cell borders. For example, adjacent single-transistor cells employing an archaic double diffusion break (DDB) would occupy three contacted poly pitches (CPP), one CPP (or dummy gate) for diffusion breaks on both sides of each single active gate, so two dummy gates between nearest active gates. Single-transistor cells using even a conventional single diffusion break (SDB) still occupy two CPP each, with a dummy gate between active gates. While a single-transistor cell is an extreme example that exaggerates the area cost of diffusion breaks, very small cells are used frequently and account for a substantial proportion of layout area on virtually all integrated circuit (IC) logic chips. NAND (Not AND) logic cells are only two transistors wide and so diffusion breaks at cell borders incur a relatively sizeable area cost. These small cells are estimated to account for more than half of typical chip area. One accepted model for transistor density uses a weighting factor of 60% for NAND cells and only 40% for larger Scan Flip-Flop cells. Especially given the prevalence of small cells, the area outlays for diffusion breaks severely constrain density advances.

New techniques, structures, and materials are needed to improve layout area utilization and to improve IC device density.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIGS. 1A, 1B, and 1C illustrate cross-sectional profile views of an integrated circuit (IC) device having source or drain material bodies in different transistor structures and a shared trench, but separated by a trench isolation, in accordance with some embodiments;
FIGS. 2A and 2B illustrate plan views of logic cells separated by zero diffusion break trench isolations, in accordance with some embodiments;
FIG. 3 illustrates a cross-sectional profile view of bisected source and drain bodies on both ends of channel regions and having first and second interface layers, in accordance with some embodiments;
FIG. 4 is a flow chart of methods for forming a dielectric isolation between and through bisected source or drain bodies, in accordance with some embodiments;
FIGS. 5A, 5B, 5C, 5D, 5E, 5F, and 5G illustrate cross-sectional profile views of an IC device having a dielectric isolation between source or drain bodies and through trenches, at various stages of manufacture, in accordance with some embodiments;
FIGS. 6A, 6B, 6C, and 6D illustrate cross-sectional profile views of an IC device having self-aligned trench isolations between source or drain bodies in a same trench, at various stages of manufacture, in accordance with some embodiments;
FIGS. 7A, 7B, 7C, and 7D illustrate cross-sectional profile views of an IC device having highly conductive interface layers on semiconductor bodies and contacting trench isolations, at various stages of manufacture, in accordance with some embodiments;
FIG. 8 illustrates a diagram of an example data server machine employing an IC device having trench isolations between retained portions of bisected source and drain material bodies, in accordance with some embodiments; and
FIG. 9 is a block diagram of an example computing device, in accordance with some embodiments.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the spirit and scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicate that two or more elements are in either direct or indirect (with other intervening elements between them) physical or electrical contact with each other, and/or that the two or more elements co-operate or interact with each other (e.g., as in a cause-and-effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Thus, cross-sectional and profile views are taken in the x-z and y-z planes, and plan views are taken in the x-y plane. Typically, profile views in the x-z plane are cross-sectional views. Where appropriate, drawings are labeled with axes to indicate the orientation of the figure.

Materials, structures, and techniques are disclosed to increase integrated circuit (IC) device density. Zero diffusion break (ZDB) isolations allow transistors (e.g., field-effect transistors, FETs) and logic cells to be more closely situated, and valuable layout area to be conserved between transistors at cell borders, by isolating adjacent devices with a dielectric between reduced-width source and drain bodies in a shared trench between channel regions.

Instead of wasting an entire contacted poly pitch (CPP) between adjacent source-drain trenches at every cell border, a trench isolation may be used within a single trench, while still using the trench for source-drain epitaxial bodies for both adjacent channels and transistors. After growth, source-drain epi may be bisected and isolated by a dielectric layer or plug between the separated epi portions, which may then have a width (e.g., in the direction of the channel length) less than half of a conventional source-drain epi width, for example, about a third of a conventional source-drain epi width. The improved source-drain epi width may similarly be less than half of a channel length, for example, about a third of a channel length. Other source-drain epi, for example, within cells, away from cell edges or borders, may be maintained, unsplit, e.g., to maintain consistent pitches between channels and gates.

Source-drain epi may be bisected, for example, by etching a vertical opening through the epi, leaving separated epi portions to either side of the opening. The opening may be used to metallize exposed surfaces, e.g., sidewalls, of the bisected epi portions, which may reduce resistances between transistor channel regions and source-drain contacts on the source-drain epi. Separated epi portions may be contacted on opposite, front- and back-sides to increase spacing between contacts and vias, this minimizing associated parasitic capacitances.

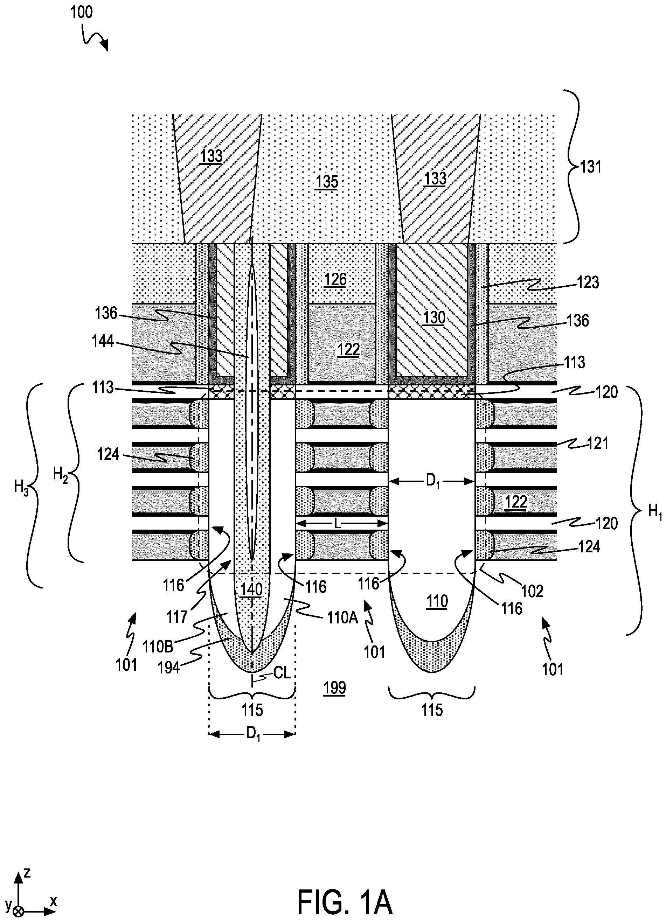

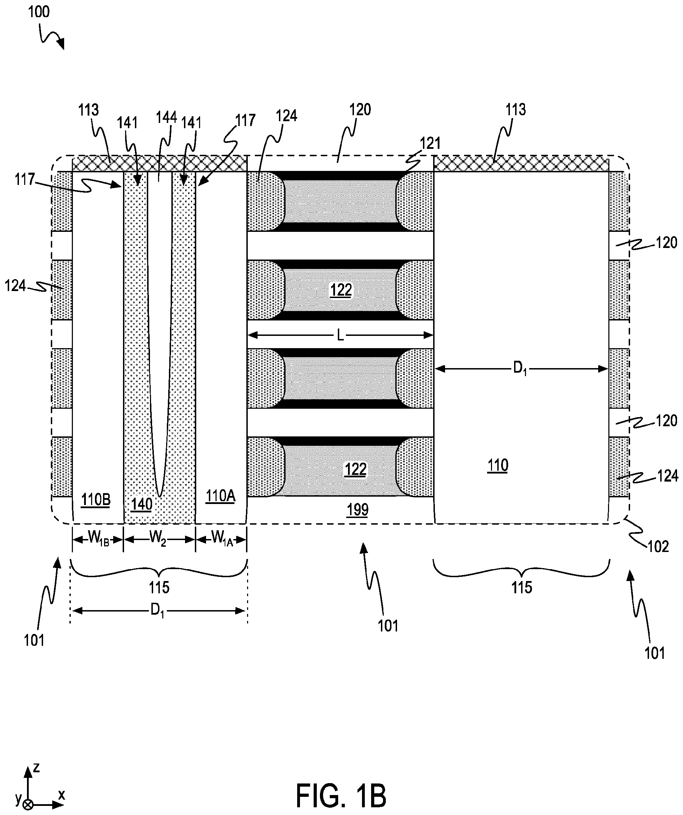

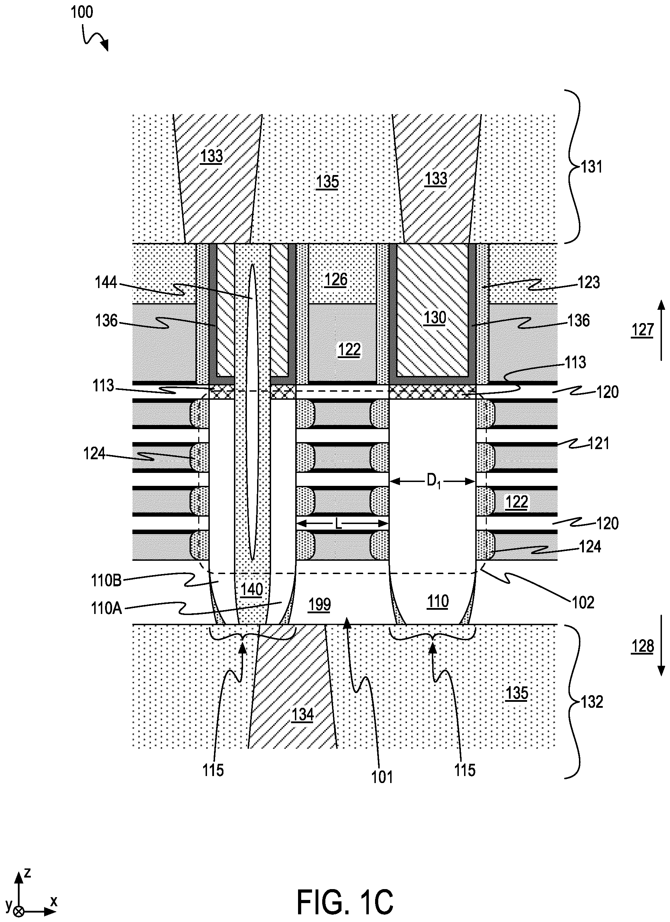

FIGS. 1A, 1B, and 1C illustrate cross-sectional profile views of an IC device 100 having source or drain material bodies 110A, 110B in different transistor structures 101 and a shared trench 115, but separated by trench isolation 140, in accordance with some embodiments. FIG. 1A includes a view 102 of a portion of FIG. 1A, and FIG. 1B shows view 102 at a greater magnification. Lateral area is conserved by isolating adjacent transistor structures 101 with isolation 140 within a single trench 115 between structures 101, rather than spending an entire gate pitch (e.g., channel length L plus distance D₁) on isolation.

FIG. 1A illustrates stacks of transistor channel regions 120 in transistor structure 101 separated by a distance Di from adjacent stacks of transistor channel regions 120 in adjacent transistor structures 101. Source or drain material bodies 110A, 110B are in a first trench 115, each body 110 coupled with one or more transistor channel regions 120 to a corresponding source or drain material body 110 in an adjacent, second trench 115. The corresponding source or drain material body 110 in adjacent trench 115 may span the distance Di between the stacks of transistor channel regions 120, coupled with the stacks of transistor channel regions 120 to both sides of body 110. Bodies 110A, 110B and trench isolation 140 collectively span distance Di across first trench 115 between stacks of transistor channel regions 120. Regions 120 may be in any suitable structure. For example, transistor structures 101 may be FinFETs, and channel regions 120 may be in fins of semiconductor material. In the example of FIG. 1A, transistor channel regions 120 are stacks of nanoribbons in each transistor structure 101. Regions 120 have a channel length L between source or drain material bodies 110. Length L of regions 120 is approximately equal to distance Di between regions 120.

Trenches 115 may extend longitudinally in the y-direction with a width equal to distance Di between adjacent stacks of regions 120. Trenches 115 may extend through and between other stacks of regions 120, e.g., not-shown, in front and behind the x-z viewing plane of FIG. 1A. Sidewalls of trenches 115 include substantially planar sidewall faces 116 of source or drain material bodies 110. For example, in cross-section, sidewall faces 116 are substantially linear and vertical along the ends of channel regions 120. Sidewalls of trenches 115 contact ends of channel regions 120 on faces 116 and spacers 124 between channel regions 120. Sidewalls of trenches 115 may also extend up to contact spacers 123 on faces 116 and above channel regions 120. Trenches 115 may have a curved, e.g., U-shaped bottom, in substrate 199 below channel regions 120. Trenches 115 may be formed by cuts or etches into substrate 199 that divide stacks of longer channel regions 120 into the shorter stacks of channel regions 120 in FIG. 1A, though trenches 115 may be formed by other means.

Each of source or drain bodies 110A, 110B is coupled with a respective stack of channel regions 120. Bodies 110A, 110B are in a cut or trench 115, within a same or single distance Di between stacks of transistor channel regions 120. Trench isolation 140 is also within the same or single distance Di between stacks of transistor channel regions 120, between the pair of source or drain material bodies 110A, 110B. Trench isolation 140 is in contact with and separates source or drain material bodies 110A, 110B. Trench isolation 140 is in contact with faces 117 of bodies 110A, 110B. Trench isolation 140 and source or drain material bodies 110A, 110B separate adjacent stacks of transistor channel regions 120, and the adjacent stacks of transistor channel regions 120, isolation 140, and bodies 110A, 110B are contiguous. Trench isolation 140, separating adjacent bodies 110A, 110B, also separates adjacent transistor structures 101. The dielectric material of isolation 140 extends at least a height Hi of the pair of source or drain material bodies 110A, 110B between the first and the second of the pair of bodies 110A, 110B. Height Hi of bodies 110A, 110B extends up to (or above) a top, contacted channel region 120 and down to (or below) a bottom, contacted channel region 120. Bodies 110A, 110B may include an interface layer 113 at a top of bodies 110A, 110B. Bodies 110A, 110B may extend into substrate 199 well below regions 120.

Trench isolation 140 includes a dielectric material within distance Di and between the pair of source or drain material bodies 110A, 110B. Isolation 140 may provide insulation, e.g., electrical insulation, between adjacent bodies 110A, 110B and transistor structures 101. Trench isolation 140 advantageously includes a low-permittivity ("low-K") dielectric material. In many embodiments, isolation 140 includes oxygen, e.g., in a silicon oxide. The dielectric material of isolation 140 may be any suitable material. The inclusion of nitrogen and/or carbon in isolation 140 may beneficially provide an etch selectivity with other adjacent dielectric materials (for example, that include oxygen). In many embodiments, isolation 140 includes nitrogen, e.g., in a silicon nitride. In some embodiments, isolation 140 includes nitrogen and oxygen, e.g., in a silicon oxynitride. In some embodiments, isolation 140 includes carbon, e.g., in a carbon-doped silicon nitride or silicon oxynitride. Trench isolation 140 need not include silicon, but compounds of silicon may provide convenience in fabrication processes including silicon structures.

Isolation 140 may substantially consist of a dielectric material, but may also include, for example, a void 144, which may improve insulation between adjacent bodies 110A, 110B and structures 101. Void 144 may include gases (such as nitrogen, oxygen, etc.), for example, a representative sample of the contents of a processing chamber during the formation of trench isolation 140. Void 144 may have a relative permittivity at or approaching vacuum permittivity. The dielectric material of isolation 140 having a low relative permittivity and/or isolation 140 including void 144 may provide improved electrical insulation by reducing parasitic coupling between adjacent bodies 110A, 110B and structures 101.

Trench isolation 140 may be a dielectric layer or plug formed in an opening made between source or drain material bodies 110A, 110B, e.g., in an opening bisecting a previously unitary or single body 110 spanning distance Di between regions 120. Bodies 110A, 110B may be symmetric about isolation 140 bisecting trench 115, for example, being mirror-images or reflections of each other. In many embodiments, bodies 110A, 110B are symmetrical about a vertical axis (e.g., centerline CL) through trench isolation 140. In some embodiments, bodies 110A, 110B both have a longer face 117 on isolation 140 and a shorter face 116 on channel regions 120 (e.g., in the z-dimension). For example, a height H₃ of face 117 is greater than a height H₂ of face 116. Bodies 110A, 110B may have curved surfaces at a bottom of trench 115, on substrate 199 (or, e.g., a dielectric spacer 194 on substrate 199) and beneath substantially planar or linear faces 116, 117. Dielectric spacer 194 may be on substrate 199 at a bottom of trench 115. Dielectric spacer 194 may be of the same dielectric material as spacers 124 between channel regions 120.

Source and drain material bodies 110 (e.g., bodies 110A, 110B) are electrically and physically coupled to opposite ends of channel regions 120. Source and drain material bodies 110 are impurity doped regions., e.g., semiconductor material doped with one or more electrically active impurities. In many embodiments, bodies 110 are either mostly silicon or mostly silicon germanium and with small quantities of donor or acceptor dopants. Impurity doped bodies 110 may have increased charge-carrier availabilities and associated conductivities. Source and drain material body 110 may be doped with an opposite type (e.g., n- or p-type) or of similar type to channel region 120. Source and drain material body 110 may include a predominant semiconductor material, and one or more n-dopants (such as phosphorus, arsenic, or antimony) or p-type impurities (such as boron or aluminum). Other dopant materials may be used. Any suitable means of formation may be used. Material body 110 may be epitaxially grown semiconductor regions, for example, of a Group IV semiconductor material (e.g., Si, Ge, SiGe, GeSn alloy). Other semiconductor materials may be employed. Material body 110 is substantially crystalline. Source and drain material bodies 110 may be polycrystalline, e.g., having long-range order at least adjacent ends of channel regions 120 and merging or joining into a unitary body with few grain boundaries. Source and drain material bodies 110 may be substantially monocrystalline.

Source and drain bodies 110 may include an interface layer 113, e.g., with very low contact resistivity and for contacting metallization structures 130 over bodies 110. In many embodiments, source or drain bodies 110 include a highly conductive interface layer 113 having one or more metals. For example, material bodies 110 of silicon (including bodies 110 of silicon germanium) may have a metal alloyed with silicon in interface layer 113 at a top of body 110. In some embodiments, body 110 includes interface layer 113 having titanium and silicon. In some embodiments, body 110 includes interface layer 113 having silicon and one of cobalt, nickel, ruthenium, platinum, or tungsten. Other metals may be deployed.

In many embodiments, at least some of transistor structures 101 are physically symmetrical about channel regions 120, and identifiers for source and drain material bodies 110 may be reversed interchangeably in many contexts. However, the classification of source and drain material body 110 may be by the electrical relationships of transistor structure 101 and material body 110 to other components in a given circuit (e.g., and the consequent direction of current flow through structure 101 and material body 110).

Channel regions 120 may be any suitable structure. In some embodiments, stacks of regions 120 include more or fewer nanoribbons (e.g., three nanoribbons each). In some embodiments, rather than stacks, source and drain bodies 110 are coupled by single nanoribbon channel regions 120. Nanoribbon channel regions 120 may have any suitable width, including sufficiently narrow or wide widths to be characterized as nanowires or nanosheets, respectively. In some embodiments, channel regions 120 are in substantially vertical fins coupling between bodies 110.

Channel regions 120 may be of any suitable material(s), for example, one or more semiconductor materials. Channel regions 120 may be of silicon, germanium, silicon germanium (e.g., Si₁₋ₓGeₓ), a III-V alloy material (such as gallium arsenide or gallium nitride), or other materials. Suitable materials may include two-dimensional (2D) materials (e.g., transition-metal dichalcogenides (TMD)) or semiconductor films (e.g., of certain metal oxides). Channel region semiconductor materials may be doped with one or more electrically active impurities, e.g., to increase channel conductivities.

Transistor structure 101 includes a gate electrode 122 and gate dielectric 121 in a gate structure over and adjacent channel regions 120. The gate structure includes gate dielectric 121 on channel region 120, e.g., on and around each nanoribbon. The gate structure includes gate electrode 122 between adjacent metallization structures 130 (e.g., over each source or drain body 110), and with gate dielectric 121 between gate electrode 122 and each channel region 120 (e.g., nanoribbons). Gate dielectric 121 provides electrical insulation between channel region 120 and gate electrode 122, and enables electrostatic control of channel region 120 (and of the conduction of region 120) by an electric signal on gate electrode 122. Conduction of channel region 120 may electrically couple adjacent source and drain bodies 110 and the respective metallization structures 130 coupled to bodies 110.

Gate dielectric 121 may have more than one layer. Gate dielectric 121 may be of any suitable material(s). The one or more layers of gate dielectric 121 may include a silicon oxide, silicon dioxide (SiO₂), a silicon oxynitride, etc. Advantageously, gate dielectric 121 includes a high-permittivity ("high-K") dielectric (for example, having a dielectric constant over 6). A high-K dielectric material may include one or more of various elements, such as hafnium, silicon, oxygen, titanium, tantalum, lanthanum, aluminum, zirconium, barium, strontium, yttrium, lead, scandium, niobium, and zinc. Gate dielectric 121 may include a dopant, e.g., for elevated permittivity.

Gate electrode 122 is on gate dielectric 121 and may include of at least one of a p- or an n-type work function metal (WFM), depending on whether the transistor is a pMOS or nMOS transistor. In some embodiments, gate electrode 122 is a stack of two or more metal layers, where one or more metal layers are WFM layers and at least one metal layer is a fill metal layer. In a pMOS transistor, for example, metals that may be utilized for gate electrode 122 include, but are not limited to, ruthenium, palladium, platinum, cobalt, nickel, and conductive metal oxides, e.g., ruthenium oxide. A p-type metal layer will enable the formation of a pMOS gate electrode 122 with a work function that is between about 4.9 eV and about 5.2 eV. These or other metals may be deployed in gate electrode 122 in an nMOS transistor, including hafnium, zirconium, titanium, tantalum, aluminum, alloys of these metals, carbides of these metals (such as hafnium carbide, zirconium carbide, titanium carbide, tantalum carbide), etc. An n-type metal layer will enable the formation of an nMOS gate electrode 122 with a work function that is between about 3.9 eV and about 4.2 eV.

Metallization structure 130 is a conductive (e.g., metal) structure that contacts source or drain bodies 110. Structures 130 couple source and drain bodies 110 (and transistor structures 101) to interconnect layers, e.g., in interconnect network 131 over transistor structures 101. Structures 130 contact each of source and drain bodies 110 at interface layer 113. Metallization structures 130 may include any suitable material(s). In some embodiments, structures 130 include a stack of two or more metal layers, e.g., where at least one included metal layer is a liner layer 136, and at least one metal layer is a fill metal layer. In many embodiments, structures 130 include one or more of copper, gold, tantalum, cobalt, tungsten, ruthenium, molybdenum, aluminum, and nickel, including in alloys. In some embodiments, structures 130 include nitrides of metals, e.g., tantalum and titanium. Structures 130 may include other electrically conductive materials, including non-metals.

Interconnect network 131 may be a front- or back-side network 131 and may include any suitable number of interconnect layers. Network 131 includes via structures 133, which extend through dielectric isolation 135 and contact structures 130. Dielectric isolation 135 may be an interlayer dielectric (ILD), e.g., a low-K dielectric material that isolates via and other metallization structures 133.

In the cross-sectional view of FIG. 1A, metallization structure 130 on source or drain body 110B is coupled to interconnect network 131 at via structure 133 in the visible x-z plane. Metallization structure 130 on source or drain body 110A may be contacted by a via structure 133 behind or in front of the viewing plane (e.g., deeper or shallower on the y-axis than the visible x-z plane).

Spacer 123 provides isolation between metallization structures 130 and gate electrodes 122. Spacer 123 is in contact with structures 130 (e.g., at layer 136) and gate electrodes 122. Spacer 123 may be of any suitably insulating material. For example, spacer 123 advantageously includes a low-K dielectric material, provides electrical insulation, and reduces parasitic coupling between adjacent structures 130 and electrodes 122.

Spacer 124 similarly provides isolation between source and drain material bodies 110 and gate electrodes 122. Spacer 124 is in contact with bodies 110 and gate electrodes 122. Spacer 124 is also between and in contact with channel regions 120 between source and drain bodies 110 and gate electrodes 122. Spacer 124 may be of any suitably insulating material, advantageously a low-K dielectric to minimize parasitic coupling between adjacent bodies 110 and gate electrodes 122. Spacers 123, 124 may be of the same electrically insulating material.

Insulating layer 126 is of a dielectric material, for example, a low-K dielectric material, that provides electrical isolation between metallization structures 130, between metallization structures 130 and interconnect layers in network 131, between gate electrodes 122 and network 131, etc. Layer 126 may offer an etch selectivity with other adjacent dielectric materials. In some embodiments, gate electrode 122 is contacted by a via structure 133 (not shown; e.g., between spacers 123) extending through layer 126 (e.g., and dielectric isolation 135). In some embodiments, gate electrode 122 is contacted by a metallization structure 130 (not shown; e.g., on electrode 122, between spacers 123) in the place of a depopulated portion of layer 126.

Substrate 199 may include any suitable material or materials. In some examples, substrate 199 may include monocrystalline silicon (including silicon on insulator (SOI)), polycrystalline silicon, germanium, silicon germanium, a III-V alloy material (e.g., gallium arsenide), a silicon carbide (e.g., SiC), a sapphire (e.g., Al₂O₃), or any combination thereof. Substrate 199 may refer specifically to a base material (for example, a thick base or layer of semiconductor material) that other materials (such as metals and dielectrics) are built up on. In some contexts, substrate 199 may refer to a base material layer and any build- up layers, etc., over the base. In many embodiments, substrate 199 includes a semiconductor material under bodies 110 and regions 120, and channel regions 120 are of the same semiconductor material. In some such embodiments, trenches 115 are cut through silicon channel regions 120 (e.g., nanoribbons) and into silicon substrate 199. Substrate 199 may also include other semiconductor materials, metals, dielectrics, dopants, and other materials commonly found in semiconductor substrates.

FIG. 1B shows magnified view 102 of FIG. 1A, including trench isolation 140 bisecting trench 115 and separating material bodies 110A, 110B and transistor structures 101. Source or drain material bodies 110A, 110B share a first trench 115, but are in separate transistor structures 101 and coupled with separate stacks of channel regions 120. For example, source or drain material body 110A is coupled by channel regions 120 to a source or drain material body 110 spanning distance Di across an adjacent, second trench 115.

Isolation 140 includes void 144, which may improve insulation between adjacent bodies 110A, 110B and structures 101. Void 144 is between first and second layers 141 of the dielectric material of trench isolation 140. For example, a first layer 141 is between void 144 and source or drain material body 110B in a first transistor structure 101, and a second layer 141 is between void 144 and source or drain material body 110A in a second transistor structure 101. First and second layers 141 may be a single, continuous layer, e.g., of dielectric material of trench isolation 140 connecting beneath void 144. For example, trench isolation 140 may be formed by depositing a dielectric material layer 141 in an opening bisecting a source or drain material body 110 and trench 115 and forming bodies 110A, 110B. The dielectric material layer 141 may be deposited on faces 117 of both bodies 110A, 110B and below faces 117 adjacent a bottom of trench 115 (e.g., on substrate 199 or on a spacer 194 as described at FIG. 1A), and layer(s) 141 may contain void 144 within layer(s) 141, between layer 141 underneath void 144 and where deposited layers 141 meet over void 144 (e.g., as shown at FIG. 1A, beneath dielectric isolation 135).

Collectively, bodies 110A, 110B and trench isolation 140 span distance D₁ across first trench 115 between stacks of transistor channel regions 120. Source or drain material body 110B has a first width W_{1B}, source or drain material body 110A has a second width W_{1A}, and isolation 140 has a thickness W₂, within distance Di and between the pair of source or drain material bodies 110A, 110B. A sum of thickness W₂ and widths W_{1A}, W_{1B} is equal to distance D₁. Trench isolation 140 bisects trench 115, and bodies 110A, 110B have equal widths W_{1A}, W_{1B}. In some embodiments, bodies 110A, 110B have widths W_{1A}, W_{1B} each equal to thickness W₂, and widths W_{1A}, W_{1B}, and thickness W₂ are each equal to a third of distance D₁. These equal proportions of widths W_{1A}, W_{1B} and thickness W₂ may allow for a sufficiently large cut or etch through trench 115, but also sufficiently large bodies 110A, 110B (e.g., to ensure sufficient conductance and mechanical strength through an entire height of bodies 110A, 110B). In some embodiments, bodies 110A, 110B have widths W_{1A}, W_{1B} each equal to twice thickness W₂, and widths W_{1A}, W_{1B} are each equal to two-fifths of distance D₁. These proportions of widths W_{1A}, W_{1B} larger than thickness W₂ may be enabled by a precise cut or etch through trench 115, and may provide increased conductance and mechanical strength of bodies 110A, 110B. In some embodiments, bodies 110A, 110B have widths W_{1A}, W_{1B} each equal to a half of thickness W₂, and widths W_{1A}, W_{1B} are each equal to a fourth of distance D₁. These proportions of thickness W₂ larger than widths W_{1A}, W_{1B} may be enabled by bodies 110A, 110B having increased conductance, and may allow for a less-precise cut or etch through trench 115. In some such embodiments, bodies 110A, 110B have widths W_{1A}, W_{1B} each approximately equal to a thickness of dielectric layer 141.

Regions 120 have channel length L between source or drain material bodies 110. Length L of regions 120 is approximately equal to distance Di between regions 120. In some embodiments, length L is longer than distance D₁. In some such embodiments, bodies 110A, 110B have widths W_{1A}, W_{1B} each approximately equal to a fourth of channel length L.

FIG. 1C illustrates a similar IC device 100 (or, e.g., similar portion of same device 100) having source or drain material bodies 110A, 110B in different transistor structures 101 and separated by trench isolation 140 bisecting a shared trench 115. In the example of FIG. 1C, transistor structures 101 are each coupled to one or both of front- and back-side interconnect networks 131, 132. Interconnect network 132 includes metallization or via structure 134, which is similar to metallization or via structure 133, but on a side 128 opposite a side 127 of via structure 133 and network 131. For example, interconnect network 132 may be on a back side 128, opposite interconnect network 131 on a front side 127. Transistor structures 101 may be in a device layer between front- and back-sides 127, 128. A first metallization structure 130 is in contact with source or drain material body 110 (coupled with channel regions 120 to body 110A). A second metallization structure 134 is in contact with source or drain material body 110A. A third metallization structure 130 is in contact with source or drain material body 110B. First and third metallization structures 130 are on first side 127 of the stacks of transistor channel regions 120 and second metallization structure 134 is on second side 128 of the stacks of transistor channel regions 120, opposite first side 127.

Source or drain bodies 110 (including bodies 110A, 110B) include interface layers 113 in contact with metallization structures 130. In some embodiments, bodies 110A, 110B include similar interface layers 113 on side 128, opposite side 127, e.g., in contact with via structures 134.

In some embodiments, a back-side interconnect network (e.g., network 132) is coupled to structures 101 and bodies 110 after a back-side grind removes portions of substrate 199, including bottoms (e.g., including at least some of curved surfaces) of trenches 115 below structures 101 and remainders of bodies 110. Trenches 115 may still be apparent as gaps or breaks between otherwise aligned channel regions 120, for example, having sidewalls at faces 116 of bodies 110. In some embodiments, trenches 115 extend in the y-direction through multiple, parallel rows of channel regions 120 extending in the x-direction. As such, trenches 115 may be apparent in a plan view as gaps or breaks between otherwise aligned channel regions 120.

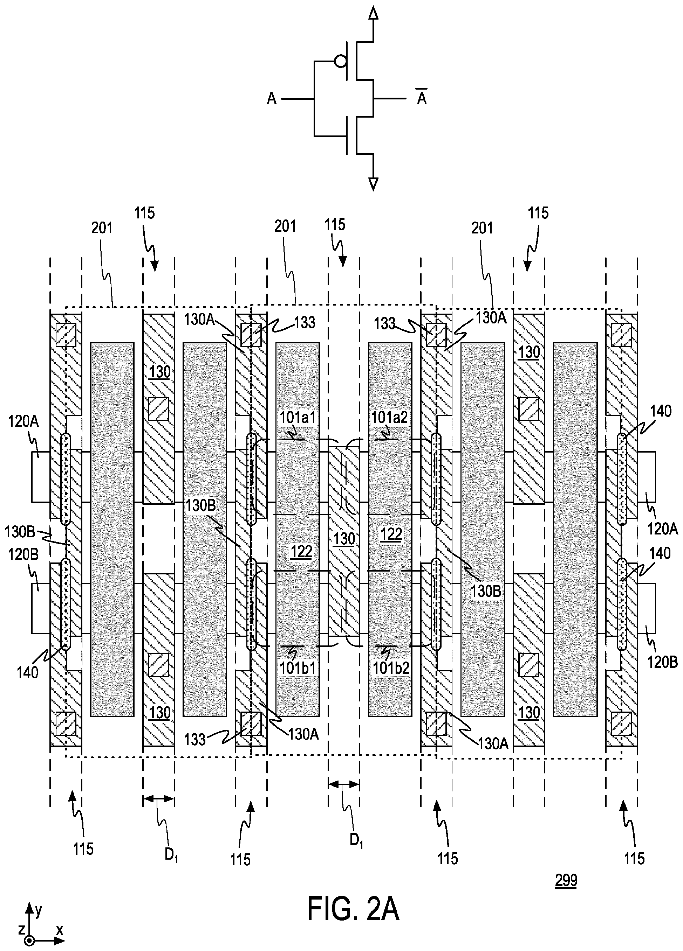

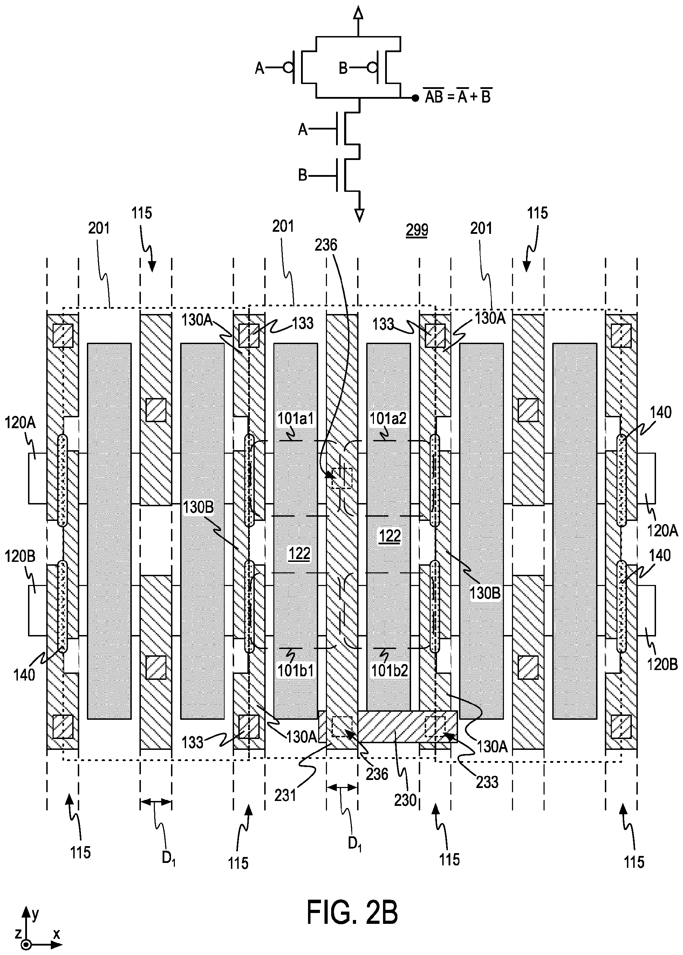

FIGS. 2A and 2B illustrate plan views of logic cells 201 separated by zero diffusion break trench isolations 140, in accordance with some embodiments. For example, FIG. 2A shows an inverter logic cell 201 separated from adjacent cells 201 by isolations 140 (e.g., between adjacent metallization structures 130A, 130B). Cells 201 are indicated by dotted borders, which at least roughly delineate transistor structures 101 of cells 201. For example, dotted borders of cells 201 run through trench isolations 140 between adjacent structures 101, channel regions 120, and metallization structures 130A, 130B. Dotted borders of cells 201 may also run through structures (such as structures 130A, 133) that are associated with a single cell 201.

The zero diffusion break trench isolations 140 produce significant layout area savings relative to conventional solutions. FIG. 2A shows three cells 201 with two-transistor widths, i.e., occupying six CPP. An old, double diffusion break (DDB) system would only be able to fit two cells into six CPP if it had single-transistor widths. A conventional single diffusion break (SDB) layout scheme could fit two, but not three, cells of two-transistor widths. Zero diffusion break trench isolations 140 enable improved layout area efficiency, saving chip area and/or allowing for improved performance for a same area cost, e.g., through the deployment of parallel structures (as in the case of parallel legs in inverter logic cells).

Cells 201 include transistor structures 101 with channel regions 120A, 120B. In the example of FIG. 2A, transistor structures 101 are p-type structures 101 with channel regions 120A and n-type structures 101 with channel regions 120B. For center inverter cell 201 between adjacent cells 201, source bodies of transistor structures 101 are coupled to power supplies by via structures 133 over metallization structures 130, and drain bodies are coupled together (e.g., by central metallization structure 130 coupled with both p- and n-type structures 101). A positive power supply (e.g., V_{DD}) is towards the top of FIG. 2A (e.g., in the positive y-direction), and an opposite (e.g., ground or negative) power supply (e.g., Vss) is towards the bottom of FIG. 2A (e.g., in the negative y-direction). An input A to center inverter cell 201 is coupled to gate electrodes 122, which are coupled together (not shown; e.g., by a metallization line over gate electrodes 122 and extending in the x-direction). An output A̅ from center inverter cell 201 is coupled to drain bodies at shared central structure 130 over and between p- and n-type structures 101. Center inverter cell 201 has parallel legs with two, parallel p-type transistor structures 101 with channel regions 120A electrically between the positive power supply and the central metallization structure 130 (over the shared drain body), and two, parallel n-type transistor structures 101 with channel regions 120B electrically between the opposite power supply and the central metallization structure 130 (over the shared drain body). Each parallel leg (with one p- and one n-type structure 101) has one gate electrode 122 over both channel regions 120A, 120B.

Regions 120 extend in the x-direction. Trenches 115 (with sidewalls indicated by dashed lines) extend in the y-direction and divide or separate channel regions 120. Trenches 115 have widths of distance Di between aligned (or coaxial), adjacent channel regions 120. Source or drain bodies (not shown) are in trenches 115, between regions 120 and under each structure 130. As described (at, e.g., FIG. 1A), trench isolations 140 are between pairs of adjacent source or drain bodies (not shown) and between corresponding pairs of metallization structures 130.

For inverter cell 201 shown between other cells 201, dashed boxes indicate the organization of included transistor structures 101, for example, structures 101a1, 101a2, 101b1, 101b2. Each transistor structure 101 includes gate electrode 122 over channel region 120 (e.g., a stack of nanoribbon regions 120) coupling between source and drain bodies (not shown) under metallization structures 130. Transistor structures 101a1, 101a2 are parallel, p-type legs between the positive power supply and a shared drain body and central metallization structure 130. Transistor structures 101b1, 101b2 are parallel, n-type legs between the opposite power supply and the shared drain body and central structure 130.

Transistor structure 101a1 is much as described at FIG. 1A or FIG. 1C with a source body (not shown, under structure 130A) separated from another cell 201 and transistor structure by trench isolation 140. In the example of FIG. 2A, the source body is coupled to an interconnect network (e.g., a front-side network) by via structure 133 in the positive z-direction. The source body under structure 130A is one of a first pair of source or drain material bodies separated by isolation 140 and with widths less than distance D₁, with the other of the first pair of source or drain material bodies under a structure 130B and in the adjacent cell 201 and transistor structure. The source body under structure 130A is coupled with a stack of channel region(s) 120A to a drain body (not shown, under central structure 130 coupled with both p- and n-type structures 101). Drain body under central structure 130 spans distance Di of trench 115 and between regions 120A. Transistor structure 101a1 is a p-type structure 101, and gate electrode 122 is over channel region(s) 120A, between metallization structures 130A, 130.

Transistor structure 101a2 is similar to, but is a mirror-image of, structure 101a1 reflected across an axis extending in the y-direction. Transistor structure 101a2 is also a p-type structure 101, but with a second gate electrode 122 over another stack of channel region(s) 120A (with the same drain material body between the stack and the first stack of channel regions 120A). Transistor structure 101a2 is coupled to the same power supply as structure 101a1, but through a separate via structure 133. A second pair of source or drain material bodies is split by a second trench isolation 140 between adjacent cells 201 and transistor structures. A first of the second pair of source or drain material bodies is a source body (not shown, under structure 130A) coupled to the same drain material body (not shown, spanning distance Di of trench 115 between regions 120A, and under central structure 130 coupled with both p- and n-type structures 101) by the second stack of transistor channel regions 120A. A second of the second pair of source or drain material bodies is not shown, under structure 130B. The first of the second pair of source or drain material bodies is between the second trench isolation 140 and the stack of channel region(s) 120A.

Transistor structure 101b1 is similar to structure 101a1, but is a mirror-image of structure 101a1 reflected across an axis extending in the x-direction. Transistor structure 101b1 is an n-type structure 101, coupled with the same gate electrode 122 as structure 101al, but over another stack of channel region(s) 120B. Transistor structure 101b1 is coupled with a second drain material body, under the same central structure 130 coupled with both p- and n-type structures 101, but spanning distance Di of center trench 115 between different channel regions 120B. Transistor structure 101b1 is coupled to the opposite power supply as structure 101a1 through a similar via structure 133 (e.g., to a front-side network). A third pair of source or drain material bodies is split by a third trench isolation 140 between adjacent cells 201 and transistor structures. A first of the third pair of source or drain material bodies is a source body (not shown, under another structure 130A) coupled to the second drain material body between channel regions 120B. The first of the third pair of source or drain material bodies is between the stack of channel regions 120 and the third isolation 140. (A second of the third pair of source or drain material bodies is in an adjacent cell 201 and transistor structure, under a structure 130B, separated from the first of the third pair of source or drain material bodies by isolation 140.)

Another stack of transistor channel regions 120B (the final stack of transistor channel regions 120 in central inverter cell 201) is coupled to and between the second drain material body and a first of a fourth pair of source or drain material bodies (not shown) in n-type transistor structure 101b2. Transistor structure 101b2 is similar to structures 101a2, 101b1, a mirror-image of structure 101a2 reflected across an axis extending in the x-direction and a mirror-image of structure 101b1 reflected across an axis extending in the y-direction. The fourth pair of source or drain material bodies is separated by a fourth trench isolation 140, and the second of the fourth pair of source or drain material bodies is not shown, under structure 130B and in an adjacent cell 201 and transistor structure. The first of the fourth pair of source or drain material bodies is a source body between the fourth isolation 140 and the final stack of regions 120B.

Each of the first of the first pair, the first of the second pair, the first of the third pair, and the first of the fourth pair of source or drain material bodies (all source bodies, not shown, but under respective metallization structures 130A) have approximately the same widths, less than half of distance Di (e.g., widths W_{1A}, as described at FIG. 1B). Each of the complementary others of the first, second, third, and fourth pairs of source or drain material bodies (all not shown, but under respective metallization structures 130B) have approximately the same widths, less than half of distance Di (e.g., widths W_{1A} or W_{1B}, as described at FIG. 1B). Each of the first, second, third, and fourth trench isolation 140 have the same thickness W₂, between widths W_{1A} (or widths W_{1A} and W_{1B}) within distance Di of trenches 115. A sum of thickness W₂ and widths W_{1A}, W_{1B} is equal to distance D₁.

Other, adjacent cells 201 may also be inverter cells 201 with parallel legs, for example, with single electrical connections to each power supply (e.g., through metallization structures 130) from shared source bodies (not shown; under structures 130). Drain bodies (not shown; under metallization structures 130B, on isolations 140 at borders of cells 201) on both channel regions 120A, 120B may be coupled by structures 130B. Drain bodies and structures 130B may be coupled by back-side connections, e.g., by back-side vias (not shown) and back-side metallization lines (not shown; for example, running in the x-direction, under and between regions 120A, 120B) in a back-side interconnect network (not shown).

IC device 100 (and structures 101) may be coupled to one or more power supplies on or through a host component 299 coupled to substrate 199. Host component 299 is a planar platform or substrate and may include dielectric and metallization structures. Host component 299 may mechanically support, and electrically couple to, substrate 199. At least one side of host component 299 includes interconnect interfaces, e.g., for soldering or direct bonding to one or more IC dies or other substrates. The opposite side of host component 299 may include similar interfaces or, e.g., copper pads for socketing or solder bumps for bonding to another substrate or host component, for example, a printed circuit board. Host component 299 may be any platform with interconnect interfaces, such as a package substrate or interposer, another IC die, etc. Host component 299 may itself be a die or an insulating substrate. Host component 299 may bond to any platform, such as a package substrate or interposer, another IC die, etc. In many embodiments, substrate 199 is an IC die, and host component 299 is a package substrate or interposer.

FIG. 2B illustrates a similar logic cell 201 as FIG. 2A, separated from adjacent cells 201 by isolations 140, but with different metallization structures 233, 236 and lines 230, 231 that make it a NAND (Not AND) cell 201. Gate electrodes 122 are each separate inputs A, B, e.g., with input B tied to electrode 122 of transistor structures 101a1, 101b1 (over stacks of channel regions 120A, 120B) and input A tied to electrode 122 of transistor structures 101a2, 101b2 (over stacks of channel regions 120A, 120B). The shared drain body of p-type transistor structures 101a1, 101a2 (spanning distance Di in center trench 115 between channel regions 120A) is not coupled by a trench contact structure 130 to a shared drain body of n-type transistor structures. The source body (under structure 130A) of n-type transistor structure 101b1 is, as before, tied to the opposite (e.g., ground or negative) power supply (through structures 130A, 133), but the source body of n-type transistor structure 101b2 is, in the example of FIG. 2B, the drain body of structure 101b1 (spanning distance Di in center trench 115 between different channel regions 120B). With the drain body of structure 101b2 (under structure 130A) coupled with metallization line 231 (through via structure 233 over structure 130A, metallization line 230, and via structure 236 over line 230), the n-type transistor structures 101b1, 101b2 are series-connected between the ground or negative power supply and the output node (A̅+B̅) tied to the shared drain body of p-type transistor structures 101a1, 101a2. The shared drain body of p-type transistor structures 101a1, 101a2 is coupled up to metallization line 231 through via structure 236. The shared drain body of p-type transistor structures 101al, 101a2 is coupled to the positive power supply by parallel legs through both p-type transistor structures 101a1, 101a2 (and both stacks of channel regions 120A and source bodies under both respective structures 130A).

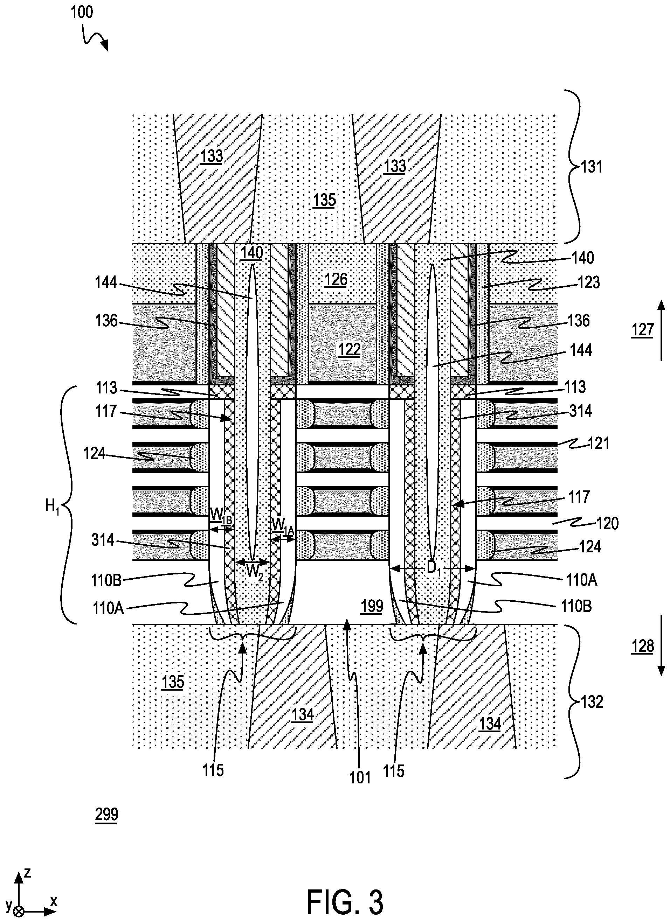

FIG. 3 illustrates a cross-sectional profile view of bisected source and drain bodies 110A, 110B on both ends of channel regions 120 and having first and second interface layers 113, 314, in accordance with some embodiments. Transistors structures 101 of FIG. 3 share similarities with structures 101 previously described (e.g., at FIG. 1C). In some embodiments, as in the example of FIG. 3, transistors structures 101 include channel regions 120 between and coupling a pair of bisected source and drain bodies 110A, 110B, e.g., where both source and drain bodies 110A, 110B have widths W_{1A} (or widths W_{1A} and W_{1B}) less than half of distance Di across trenches 115. Transistors structure 101 is separated from adjacent transistors structures 101 by trench isolations 140 to both sides. Trench isolations 140 bisect both trenches 115. Trench isolations 140 have thickness W₂ between widths W_{1A} (or widths W_{1A} and W_{1B}) within distance D₁ of trenches 115. A sum of thickness W₂ and widths W_{1A}, W_{1B} is equal to distance D₁. In at least the embodiment of FIG. 3, width W_{1A} is equal to width W_{1B}, and distance Di is equal to the sum of thickness W₂ and twice width W_{1A} (or twice width W_{1B}). In some embodiments, as in the example of FIG. 3, one of source and drain bodies 110A, 110B is coupled to via structure 133 and interconnect network 131, and the other of source and drain bodies 110A, 110B is coupled to via structure 134 and interconnect network 132. In other embodiments, both of source and drain bodies 110A, 110B is coupled to a single network 131 or 132, e.g., by via structures 133 or 134 at different depths along the y-axis. Gate electrodes 122 may be coupled to either or both of interconnect networks 131, 132.

Source and drain bodies 110 may include an interface layer 314 on face 117 and trench isolation 140. Layer 314 may extend along an entirety of face 117, e.g., along an entirety of height Hi of bodies 110A, 110B. Layer 314 may have very low resistivity and very high conductivity, e.g., due to metal content and alloying with a majority material, such as silicon, of bodies 110. Layer 314 may provide a low-resistance path from a bottom of body 110 (e.g., from via structure 134 or a lowest nanoribbon region 120) to a top of body 110 (e.g., at via structure 133 or an uppermost nanoribbon region 120).

In some embodiments, layer 314 includes one or more metals. For example, material bodies 110 of silicon (including bodies 110 of silicon germanium) may have a metal alloyed with silicon in interface layer 314 at face 117 of body 110. In some embodiments, body 110 includes interface layer 314 having titanium and silicon. In some embodiments, body 110 includes layer 314 having silicon and one of cobalt, nickel, ruthenium, platinum, or tungsten. Other metals may be deployed. Layer 314 may include the same or different metal(s) as layer 113. The deployment of different metals may offer flexibility, e.g., with a first metal for minimized resistivity in a thin, contact layer 113 and a second metal for maximized conductivity in a thicker layer 314 along face 117 and in contact with isolation 140.

Source or drain bodies 110A, 110B include interface layers 113 in contact with metallization structures 130. In some embodiments, bodies 110A, 110B include similar interface layers 113 on side 128, opposite side 127, e.g., in contact with via structures 134. Layers 113 on both sides 127, 128 may be coupled by an interface layer 314 at face 117 of body 110.

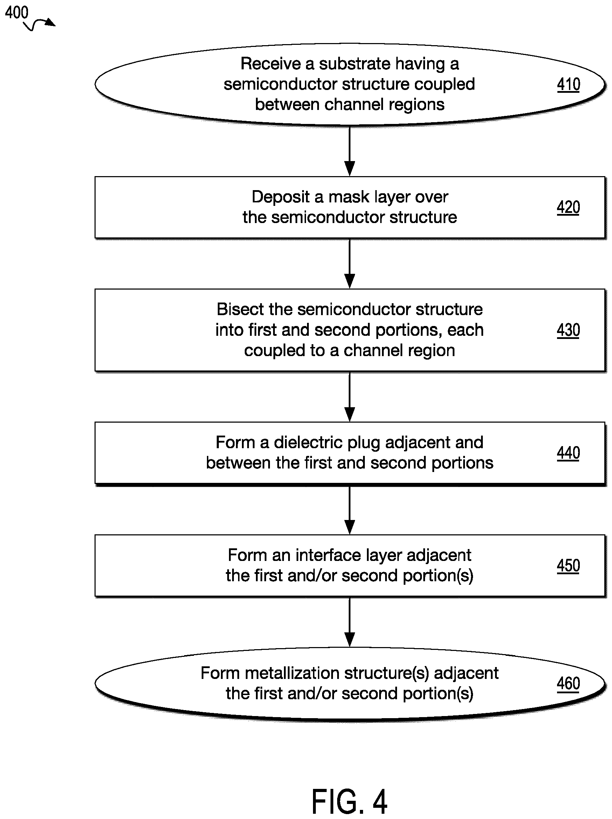

FIG. 4 is a flow chart of methods 400 for forming dielectric isolation between and through bisected source or drain bodies, in accordance with some embodiments. Methods 400 include operations 410-460. Some operations shown in FIG. 4 are optional. Additional operations may be included. FIG. 4 shows an example sequence, but the operations can be done in other orders as well, and some operations may be omitted. Some operations can also be performed multiple times before other operations are performed. For example, multiple structures may be bisected before forming a dielectric layer or plug between remainder portions of the structure(s). Some operations may be included within other operations so that the number of operations illustrated FIG. 4 is not a limitation of the methods 400.

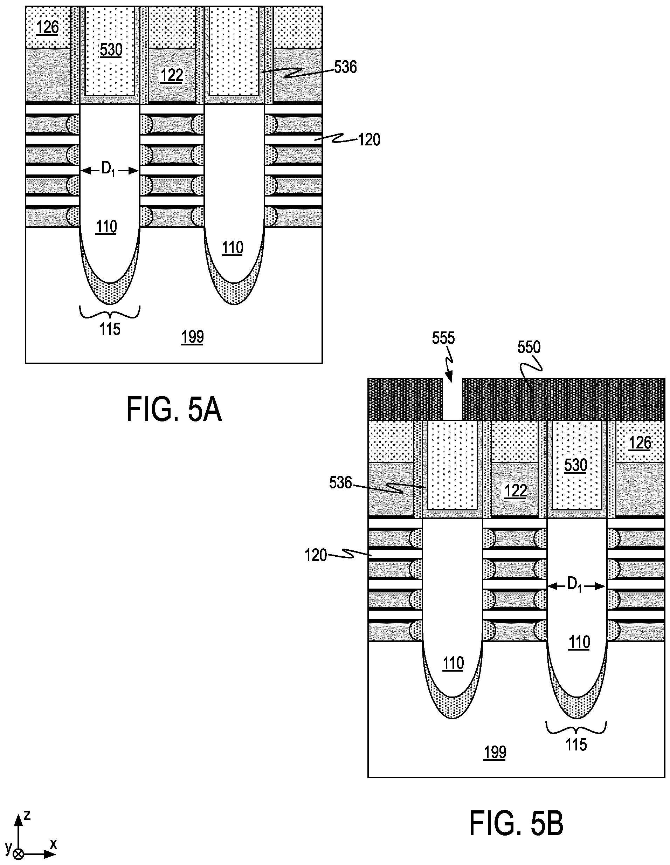

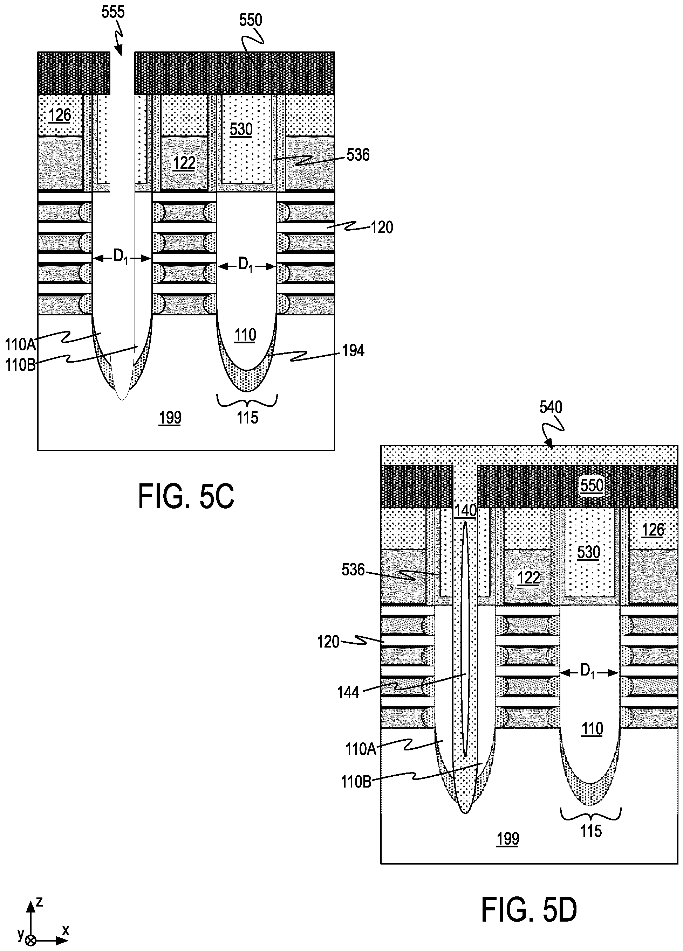

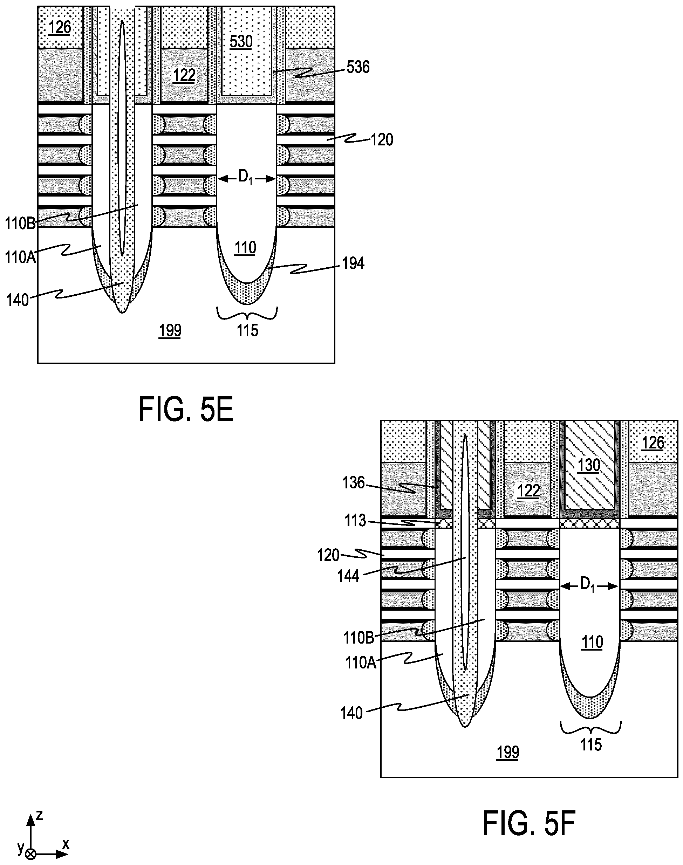

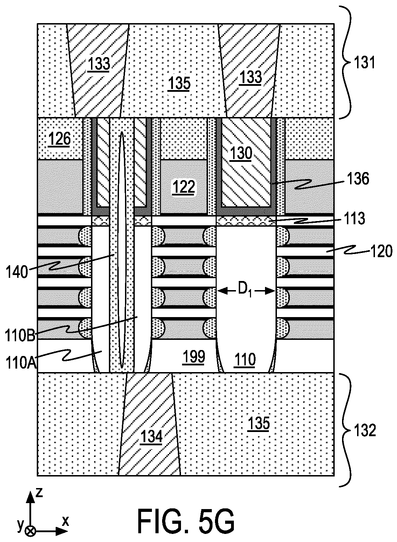

FIGS. 5A, 5B, 5C, 5D, 5E, 5F, and 5G illustrate cross-sectional profile views of IC device 100 having dielectric isolation 140 between source or drain bodies 110A, 110B and through trenches 115, at various stages of manufacture, in accordance with some embodiments. FIGS. 5A-5G show possible examples of intermediate structures during an embodiment of a practice of methods 400 of FIG. 4.

Returning to FIG. 4, methods 400 begin at operation 410 with receiving a substrate. The substrate may be substantially as previously described (e.g., at least of substrate 199 at FIG. 1A). For example, the substrate may include any suitable material or materials in any suitable structure, such as a wafer, die, etc. The substrate may include a semiconductor material that transistors can be formed out of and on, including monocrystalline silicon or silicon germanium, etc. The substrate may also include metals, dielectrics, dopants, and other materials commonly found in IC substrates.

In many embodiments, the substrate includes multiple channel regions, such as nanoribbons in adjacent stacks. The channel regions may be in other structures, such as fins. In some embodiments, the multiple channel regions are adjacent and coaxial (e.g., collinear, or aligned on a common axis). For example, multiple fins or stacks of nanoribbons may aligned on a same linear or (e.g., vertical) planar axis. In some embodiments, the channel regions may be formed on the substrate, e.g., by etching fins from or into the substrate, which may include alternating layers of semiconducting material.

In many embodiments, the substrate includes source or drain bodies between the multiple channel regions, and channel regions between the source or drain bodies. The source or drain bodies may be semiconductor material bodies or structures between and coupled to the channel regions. For example, multiple channel regions may be aligned on a same axis with cuts or etches forming trenches through the channel regions and the axis, and semiconductor material bodies or structures (i.e., source or drain bodies) may be in the trenches, spanning the distance or gap between the aligned channel regions. The semiconductor material of the source or drain bodies between the channel regions may be any suitable material. In many embodiments, the semiconductor material is silicon. In many embodiments, the semiconductor material is silicon germanium. In some embodiments, the semiconductor material is silicon for some source and drain bodies (e.g., for n-type transistors) and silicon germanium for other source and drain bodies (e.g., for p-type transistors). Other semiconductor materials may be employed.

FIG. 5A illustrates substrate 199 having source or drain bodies 110 between and coupled to channel regions 120, in accordance with some embodiments, for example, following a performance of receiving operation 410. Trenches 115 have a width of distance Di between channel regions 120, and bodies 110 span distance D₁. In the example of FIG. 5A, gate electrodes 122 are over channel regions 120, and insulating layer 126 is over electrodes 122. A dielectric fill 530 is within a dielectric liner layer 536, together forming a sacrificial dielectric structure over bodies 110.

Returning to FIG. 4, methods 400 continue with depositing a mask layer at operation 420. The mask layer may be deposited and patterned over the received substrate and provide an opening over each semiconductor structure, e.g., for subsequent etching of the semiconductor structure. The mask may be of any suitable material(s) and may be deposited by any suitable means. In many embodiments, the mask layer may include nitrogen and/or carbon, e.g., to provide an etch selectivity between the mask and dielectrics (for example, oxides) present over the source and drain semiconductor structures. In some embodiments, the mask layer is deposited and patterned using a photolithographic process.

FIG. 5B illustrates a mask layer 550 over substrate 199 and an opening 555 in and through layer 550 and over source or drain body 110, in accordance with some embodiments, for example, following a performance of depositing operation 420. Layer 550 is covering most features of substrate 199. Opening 555 is centered over source or drain body 110 with dielectric fill 530 and layer 536 between mask layer 550 and semiconductor material body 110.

Returning to FIG. 4, methods 400 continue with bisecting a semiconductor structure at operation 430. The semiconductor structure may be bisected by any suitable means. In many embodiments, the semiconductor structure is bisected by etching through an opening in the deposited mask layer, e.g., between first and second sidewalls of the deposited mask layer. The bisecting may remove a segment of semiconductor material between two retained portions of the split semiconductor structure. The bisecting (e.g., etching) may form an opening in place of the removed segment and between the two retained portions. The opening may stop on or into a dielectric material below the bisected source and drain semiconductor structures, or the opening may be into a crystalline (e.g., semiconductor) material of the substrate below the bisected source and drain semiconductor structures. Each retained portion of the semiconductor structure may be coupled to one or more channel regions on either side of the opening. In some embodiments, both retained portions are each coupled to a stack of nanoribbon channel regions.

FIG. 5C illustrates opening 555 between bisected-portion bodies 110A, 110B coupled to channel regions 120, in accordance with some embodiments, for example, following a performance of bisecting operation 430. Opening 555 is through trench 115 (including dielectric fill 530 and dielectric layer 536 over bodies 110A, 110B and dielectric spacer 194 at a bottom of trench 115) and into semiconductor material of substrate 199.

Returning to FIG. 4, methods 400 continue with forming a dielectric layer or plug at operation 440. The dielectric layer or plug may be adjacent and between the pair of retained portions of the semiconductor structure. The dielectric layer or plug may be formed by any suitable means and of any suitable material(s). In many embodiments, the dielectric layer or plug is formed by depositing layers of dielectric material adjacent and between the first and second retained portions of the semiconductor structure. For example, dielectric layers may be deposited in the opening between, on, and over the pair of retained semiconductor portions. In many embodiments, a first dielectric layer is deposited on a first retained portion, and a second dielectric layer is deposited on the second retained portion. In some such embodiments, the first and second dielectric layers are a single, continuous layer formed on sidewalls of the opening and connected at a bottom of the opening. In some such embodiments, the dielectric layer or plug includes or contains a void or opening between the first and second dielectric layers.

The dielectric material may be deposited in and over the opening. In some embodiments, the dielectric material is deposited conformally, e.g., on sidewalls of the opening, for example, by a chemical vapor deposition (CVD), such as an atomic layer deposition (ALD). The deposited dielectric material is advantageously a low-K dielectric, which (like the inclusion of a void) may improve electrical insulation (e.g., and reduce parasitic coupling) between the retained semiconductor bodies. The deposited dielectric material advantageously has an etch selectivity with adjacent dielectrics, e.g., to enable subsequent selective processing. In some embodiments, excess deposited dielectric material is removed, e.g., by a chemical-mechanical planarization or polish (CMP).

FIG. 5D illustrates isolation 140 through trench 115 and between semiconductor bodies 110A, 110B, in accordance with some embodiments, for example, following a performance of forming operation 440. Trench isolation 140 contains void 144 between bodies 110A, 110B. Dielectric material 540 of isolation 140, having filled the opening, is over substrate 199 and mask layer 550.

FIG. 5E illustrates isolation 140 between semiconductor bodies 110A, 110B, and with top layer 126 exposed and planarized, for example, following a CMP operation. The dielectric material of isolation is not present over top layer 126.

Returning to FIG. 4, methods 400 continue with forming or metallizing an interface layer at operation 450. The interface layer may serve as a highly conductive layer for low-resistance contacting of the source or drain semiconductor body or bodies. The layer may interface between the semiconductor material and a subsequently formed contact structure (e.g., of metal) over the source or drain semiconductor body or bodies. The interface layer may be formed by any suitable means and of any suitable material(s), for example, after selective removal of any dielectric and/or sacrificial materials over the source or drain semiconductor body or bodies. The interface layer may include semiconductor material and one or more metals. In many embodiments, a thin layer of the one or more metals is deposited on the semiconductor body, and the metal(s) and semiconductor react (e.g., due to an anneal) to form an alloy or compound of the semiconductor and the metal(s). In some such embodiments, the semiconductor is etched or otherwise exposed before deposition of the metal(s). In many embodiments, the interface layer includes silicon (e.g., from the semiconductor body) and one or more of titanium, cobalt, nickel, ruthenium, platinum, or tungsten. The interface layer, e.g., of both semiconductor and metal, may be characterized as part of the semiconductor body.

Methods 400 continue with optionally forming a metallization structure over one or more semiconductor structures at operation 460. In many embodiments, a metallization structure is formed over one or more of the retained semiconductor portions. Forming the metallization structure may be by any suitable means and with any suitable materials, for example, those described of metallization structure 130 at FIG. 1A. In many embodiments, the metallization structure includes one or more metal layers deposited over the retained semiconductor portions. In some such embodiments, at least one liner (e.g., conformal) layer is first deposited over a semiconductor body, and a fill layer is deposited over the liner layer(s). In many embodiments, the metallization structure is coupled to the semiconductor body (e.g., a retained semiconductor portion) by the interface layer (formed or metallized at operation 450). A deposited liner layer may alloy or otherwise bond or interface with an upper surface of the semiconductor body, for example, a highly conductive contact or interface layer of, on, or over the semiconductor body. A dielectric layer may be formed over the metallization structures, and via structures may be formed on and contacting the metallization structures, through the dielectric layer.

In some embodiments, one or more metallization structures are optionally formed on one or more semiconductor structures, but on an opposite side of a metallization structure formed at operation 460. In some such embodiments, the substrate is ground down and/or polished on a back-side of the substrate, a dielectric layer is formed over the back-side, and via structures are formed on and contacting back-sides of the one or more semiconductor structures, through the dielectric layer. In this way, metallization structures may be formed (and transistor structures may be coupled to interconnect networks) on both sides of, above and below, the channel regions and semiconductor bodies in a device layer between the formed metallization structures.

FIG. 5F illustrates metallization structures 130 on semiconductor bodies 110, coupled by interface layers 113, in accordance with some embodiments, for example, following a performance of metallizing or forming operation 450 and forming operation 460. Metallization structures 130 include metal liner layer 136 on interface layer 113. Semiconductor bodies 110 include interface layers 113. Dielectric fill 530 and dielectric layer 536 are not present over bodies 110A, 110B.

FIG. 5G illustrates metallization structures 130, 134 on front- and back-sides of semiconductor bodies 110 coupled to front- and back-side networks 131, 132 at via structures 133, 134, in accordance with some embodiments, for example, following a performance of forming operation 460.

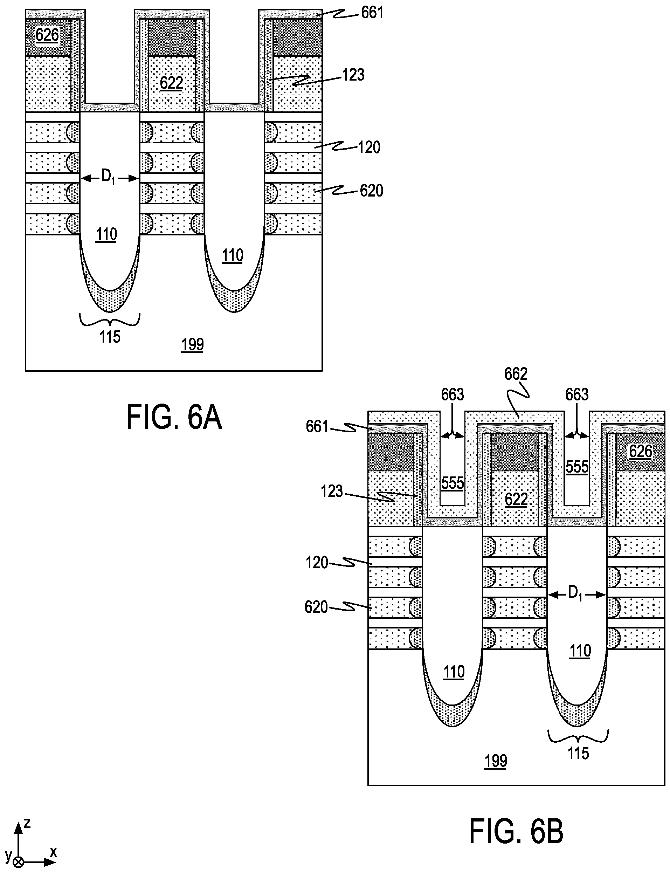

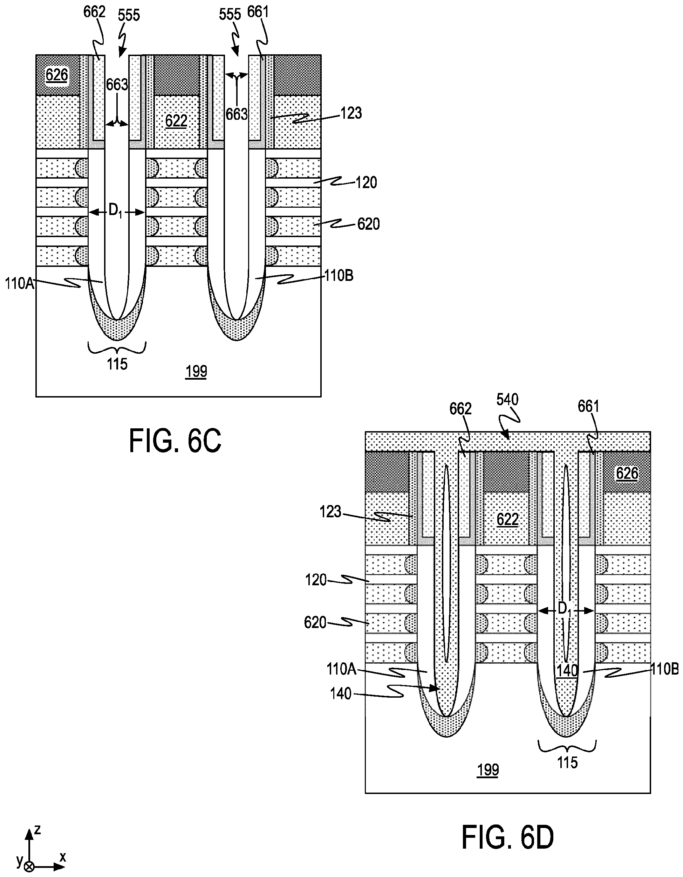

FIGS. 6A, 6B, 6C, and 6D illustrate cross-sectional profile views of IC device 100 having self-aligned trench isolations 140 between source or drain bodies 110 in a same trench 115, at various stages of manufacture, in accordance with some embodiments. FIGS. 6A-6D show example structures after or during optional example operations for bisecting source or drain bodies 110 using a conformally deposited mask layer 662 over the semiconductor bodies 110. In some embodiments, as in the examples of FIGS. 6A-6D, isolations 140 may be formed before gate electrodes over channel regions 120.

In the received substrate shown at FIG. 6A (e.g., following a receiving operation 410), channel regions 120 are not yet released, and sacrificial material 620 is between regions 120. Sacrificial, dummy-gate material 622 is over regions 120. Mask layer 626 is over dummy-gate material 622. An etch-stop layer 661 is conformally over substrate 199, including on source or drain semiconductor bodies 110 and on sidewalls of spacers 123. Layer 661 may be deposited by any suitable means, for example, conformally by an ALD or other CVD. Etch-stop layer 661 may provide an etch selectivity, e.g., between subsequently deposited mask layer 662 and one or both of spacer 123 and layer 626.

FIG. 6B illustrates mask layer 662 conformally over etch-stop layer 661, for example, following a performance of depositing operation 420. Mask layer 662 may be conformally deposited at operation 420 of methods 400 for bisecting semiconductor structure body 110 into first and second portions. Mask layer 662 may be conformally deposited to a desired thickness and corresponding width of openings 555 between sidewalls 663 of layer 662. Layer 662 may be deposited by any suitable means, for example, conformally by a CVD. Layer 662 is advantageously deposited by an operation, such as an ALD, allowing very precise control of the thickness of layer 662 (and so the width of openings 555 between sidewalls 663 of layer 662).

FIG. 6C shows openings 555 between sidewalls 663 and retained source or drain semiconductor bodies 110A, 110B coupled to channel regions 120 to both sides of trenches 115, for example, following a performance of bisecting operation 430. Openings 555 may be etched between sidewalls 663 of conformally deposited mask layer 662 and through source or drain semiconductor bodies 110 as part of bisecting operation 430. Excess material of layers 661, 662 are not present over, e.g., spacers 123 and layer 626. Excess material of layers 661, 662 may be removed by, for example, a planarization or polish.

FIG. 6D illustrates trench isolation(s) 140 of deposited dielectric material 540 between retained source or drain semiconductor bodies 110A, 110B and layers 662, for example, following a performance of forming operation 440. Gate electrodes, etc., may be formed concurrently with other subsequent operations, much as previously described (e.g., at FIGS. 4, 5D-5G).

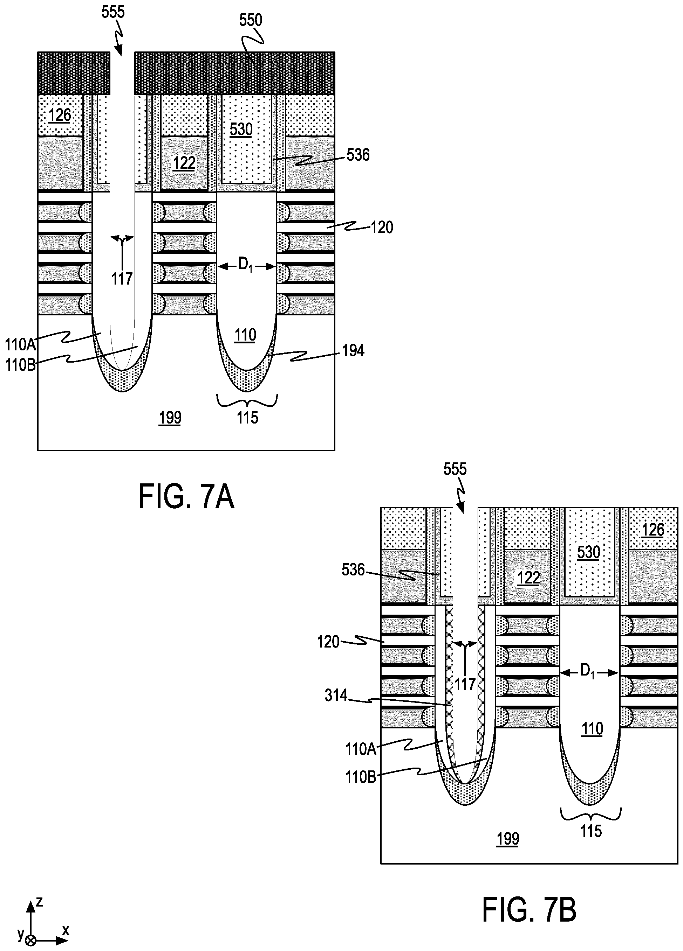

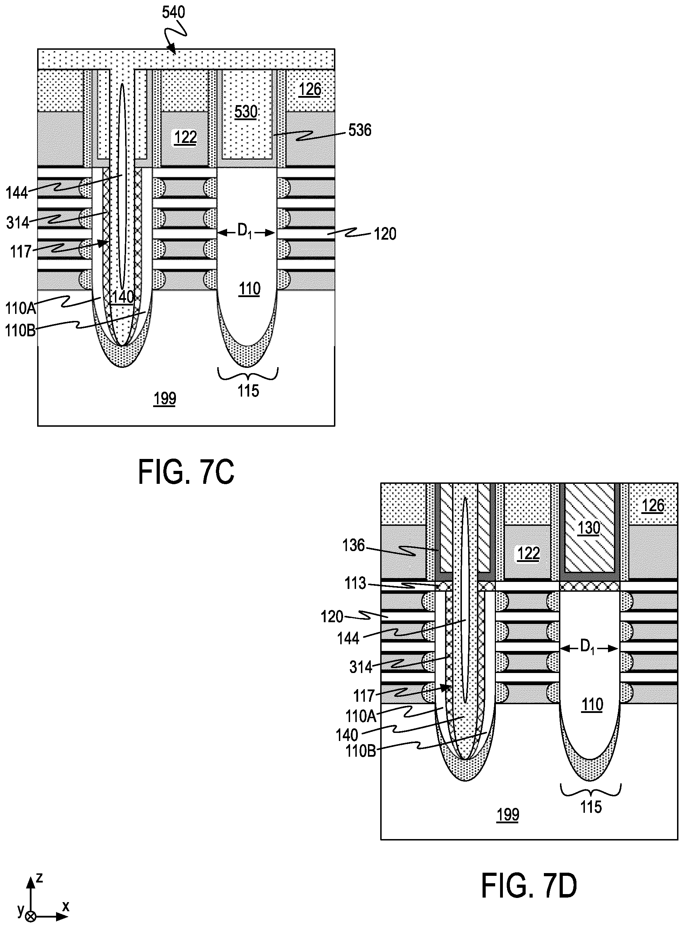

FIGS. 7A, 7B, 7C, and 7D illustrate cross-sectional profile views of IC device 100 having highly conductive interface layers 314 on semiconductor bodies 110A, 110B and contacting trench isolations 140, at various stages of manufacture, in accordance with some embodiments. FIGS. 7A-7D show example structures after or during optional example operations for forming conductive layers 314 on sidewalls or faces 117 of source or drain semiconductor bodies 110A, 110B. FIG. 7A illustrates opening 555 between bisected-portion bodies 110A, 110B coupled to channel regions 120, in accordance with some embodiments, for example, following a performance of bisecting operation 430, similar to the example of FIG. 5C. Opening 555 is substantially through trench 115 (including sacrificial fill 530 and layer 536 over bodies 110A, 110B and to or into dielectric spacer 194 at a bottom of trench 115) over semiconductor material of substrate 199. No trench isolation 140 separates bodies 110A, 110B, and sidewalls or faces 117 of bodies 110A, 110B are exposed.

FIG. 7B shows conductive layers 314 on sidewalls or faces 117 of source or drain semiconductor bodies 110A, 110B, in accordance with some embodiments, for example, following a performance of metallizing or forming operation 450 (but prior to a forming of a trench isolation, e.g., at an operation 440). Mask layer 550 is not present over substrate 199. Dielectric fill 530 and dielectric layer 536 are present over bodies 110 (including bodies 110A, 110B). Once a trench isolation is formed, layer 314 will be on or between a semiconductor body 110A or 110B and the trench isolation. The trench isolation may be formed on layer 314.

Semiconductor bodies 110A, 110B include interface layers 314. Layer 314 may be formed by a performance of metallizing or forming operation 450, after a semiconductor structure or body 110 (spanning distance Di between channel regions 120) is bisected into retained bodies 110A, 110B, for example, by etching opening 555 between bodies 110A, 110B. The etching of opening 555 between bodies 110A, 110B may expose the semiconductor material of bodies 110A, 110B. Layer 314 may be formed, e.g., metallized, by depositing one or more metals in opening 555, on sidewalls or faces 117 of semiconductor bodies 110A, 110B. The depositing metal(s) may be one or more of titanium, cobalt, nickel, ruthenium, platinum, tungsten, or any other suitable metal. The metal(s) and semiconductor material of bodies 110A, 110B may react (e.g., due to an anneal) to form an alloy or compound of the semiconductor and the metal(s). In many embodiments, layer 314 includes silicon (e.g., in semiconductor bodies 110 of silicon or silicon germanium). Interface layer 314, e.g., of both semiconductor and metal, may be characterized as part of the semiconductor body 110A or 110B.

Layer 314 may have very high conductivity. Layer 314 may provide a low-resistance path from a bottom of body 110A or 110B (e.g., from a lowest nanoribbon region 120 or subsequently formed metallization structure) to a top of body 110 (e.g., at an uppermost nanoribbon region 120 or subsequently formed metallization structure).

FIG. 7C illustrates isolation 140 through trench 115 and between semiconductor bodies 110A, 110B, in accordance with some embodiments, for example, following a performance of forming operation 440. Trench isolation 140 contains void 144 between bodies 110A, 110B. Dielectric material 540 of isolation 140, having filled the opening, is over substrate 199. As at operation 450 and FIG. 7B, mask layer 550 is not present. Trench isolation 140 may be formed at operation 440 by depositing one or more layers of dielectric material 540 of isolation 140 on layer 314, adjacent and between bodies 110A, 110B. Layers 314 are on or between respective bodies 110A, 110B and trench isolation 140.

FIG. 7D shows metallization structures 130 on semiconductor bodies 110 (including bodies 110A, 110B), coupled by interface layers 113, in accordance with some embodiments, for example, following a performance of metallizing or forming operation 450 and forming operation 460. Metallization structures 130 include metal liner layer 136 on interface layer 113. Semiconductor bodies 110 include interface layers 113. Layers 113 may include the semiconductor material of bodies and the same or different metal(s) of layer 314. Dielectric fill 530 and dielectric layer 536 are not present over bodies 110. Subsequent operations may be performed, such as formation of other metallization structures (including via structures), back-side grinding, etc.

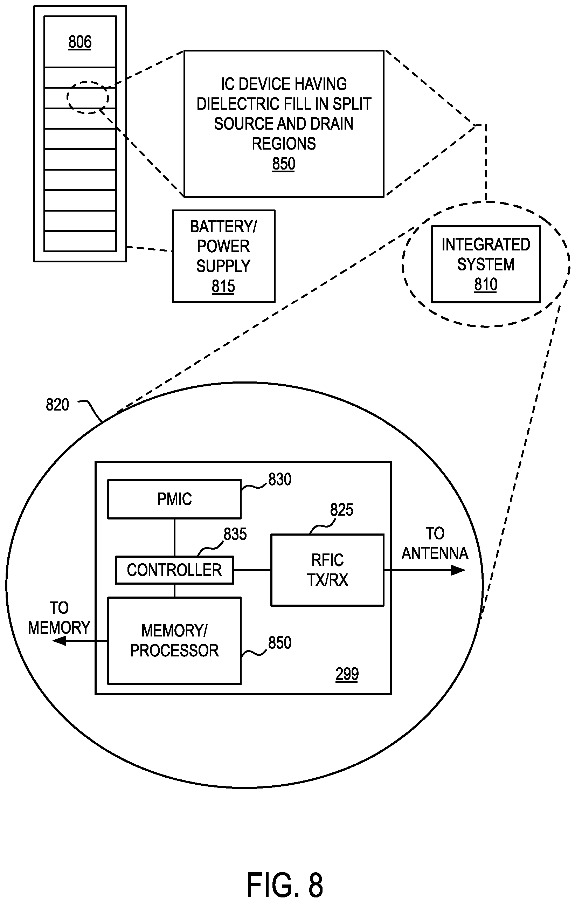

FIG. 8 illustrates a diagram of an example data server machine 806 employing an IC device having trench isolations between retained portions of bisected source and drain material bodies, in accordance with some embodiments. Server machine 806 may be any commercial server, for example, including any number of high-performance computing platforms disposed within a rack and networked together for electronic data processing, which in the exemplary embodiment includes one or more devices 850 having trench isolations between retained portions of bisected source and drain material bodies.

Also as shown, server machine 806 includes a battery and/or power supply 815 to provide power to devices 850, and to provide, in some embodiments, power delivery functions such as power regulation. Devices 850 may be deployed as part of a package-level integrated system 810. Integrated system 810 is further illustrated in the expanded view 820. In the exemplary embodiment, devices 850 (labeled "Memory/Processor") includes at least one memory chip (e.g., random-access memory (RAM)), and/or at least one processor chip (e.g., a microprocessor, a multi-core microprocessor, or graphics processor, or the like) having the characteristics discussed herein. In an embodiment, device 850 is a microprocessor including a static RAM (SRAM) cache memory. As shown, device 850 may be an IC device having trench isolations between retained portions of bisected source and drain material bodies, as discussed herein. Device 850 may be further coupled to (e.g., communicatively coupled to) a board, an interposer, or a substrate (such as host component 299) along with, one or more of a power management IC (PMIC) 830, RF (wireless) IC (RFIC) 825 including a wideband RF (wireless) transmitter and/or receiver (TX/RX) (e.g., including a digital baseband and an analog front end module further includes a power amplifier on a transmit path and a low noise amplifier on a receive path), and a controller 835 thereof. In some embodiments, RFIC 825, PMIC 830, controller 835, and device 850 include having trench isolations between retained portions of bisected source and drain material bodies.

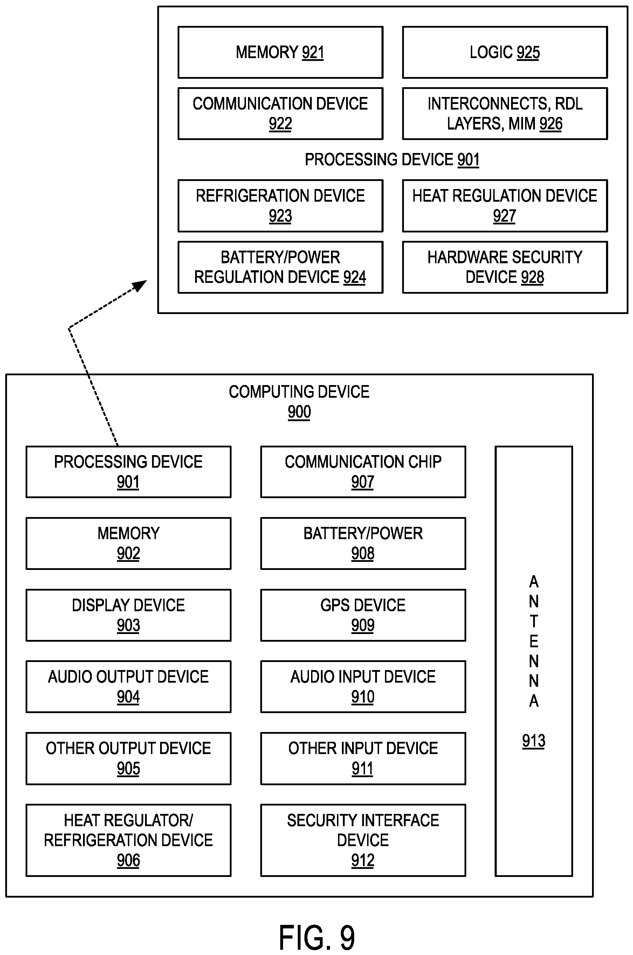

FIG. 9 is a block diagram of an example computing device 900, in accordance with some embodiments. For example, one or more components of computing device 900 may include any of the devices or structures discussed herein. A number of components are illustrated in FIG. 9 as being included in computing device 900, but any one or more of these components may be omitted or duplicated, as suitable for the application. In some embodiments, some or all of the components included in computing device 900 may be attached to one or more printed circuit boards (e.g., a motherboard). In some embodiments, various ones of these components may be fabricated onto a single system-on-a-chip (SoC) die. Additionally, in various embodiments, computing device 900 may not include one or more of the components illustrated in FIG. 9, but computing device 900 may include interface circuitry for coupling to the one or more components. For example, computing device 900 may not include a display device 903, but may include display device interface circuitry (e.g., a connector and driver circuitry) to which display device 903 may be coupled. In another set of examples, computing device 900 may not include an audio output device 904, other output device 905, global positioning system (GPS) device 909, audio input device 910, or other input device 911, but may include audio output device interface circuitry, other output device interface circuitry, GPS device interface circuitry, audio input device interface circuitry, audio input device interface circuitry, to which audio output device 904, other output device 905, GPS device 909, audio input device 910, or other input device 911 may be coupled.

Computing device 900 may include a processing device 901 (e.g., one or more processing devices). As used herein, the term "processing device" or "processor" indicates a device that processes electronic data from registers and/or memory to transform that electronic data into other electronic data that may be stored in registers and/or memory. Processing device 901 may include a memory 921, a communication device 922, a refrigeration device 923, a battery/power regulation device 924, logic 925, interconnects 926 (i.e., optionally including redistribution layers (RDL) or metal-insulator-metal (MIM) devices), a heat regulation device 927, and a hardware security device 928.

Processing device 901 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 900 may include a memory 902, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 902 includes memory that shares a die with processing device 901. This memory may be used as cache memory and may include embedded dynamic random-access memory (eDRAM) or spin transfer torque magnetic random-access memory (STT-MRAM).

Computing device 900 may include a heat regulation/refrigeration device 906. Heat regulation/refrigeration device 906 may maintain processing device 901 (and/or other components of computing device 900) at a predetermined low temperature during operation.

In some embodiments, computing device 900 may include a communication chip 907 (e.g., one or more communication chips). For example, the communication chip 907 may be configured for managing wireless communications for the transfer of data to and from computing device 900. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 907 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 907 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 907 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 907 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 907 may operate in accordance with other wireless protocols in other embodiments. Computing device 900 may include an antenna 913 to facilitate wireless communications and/or to receive other wireless communications (such as AM or FM radio transmissions).

In some embodiments, communication chip 907 may manage wired communications, such as electrical, optical, or any other suitable communication protocols (e.g., the Ethernet). As noted above, communication chip 907 may include multiple communication chips. For instance, a first communication chip 907 may be dedicated to shorter-range wireless communications such as Wi-Fi or Bluetooth, and a second communication chip 907 may be dedicated to longer-range wireless communications such as GPS, EDGE, GPRS, CDMA, WiMAX, LTE, EV-DO, or others. In some embodiments, a first communication chip 907 may be dedicated to wireless communications, and a second communication chip 907 may be dedicated to wired communications.

Computing device 900 may include battery/power circuitry 908. Battery/power circuitry 908 may include one or more energy storage devices (e.g., batteries or capacitors) and/or circuitry for coupling components of computing device 900 to an energy source separate from computing device 900 (e.g., AC line power).

Computing device 900 may include a display device 903 (or corresponding interface circuitry, as discussed above). Display device 903 may include any visual indicators, such as a heads-up display, a computer monitor, a projector, a touchscreen display, a liquid crystal display (LCD), a light-emitting diode display, or a flat panel display, for example.

Computing device 900 may include an audio output device 904 (or corresponding interface circuitry, as discussed above). Audio output device 904 may include any device that generates an audible indicator, such as speakers, headsets, or earbuds, for example.

Computing device 900 may include an audio input device 910 (or corresponding interface circuitry, as discussed above). Audio input device 910 may include any device that generates a signal representative of a sound, such as microphones, microphone arrays, or digital instruments (e.g., instruments having a musical instrument digital interface (MIDI) output).

Computing device 900 may include a GPS device 909 (or corresponding interface circuitry, as discussed above). GPS device 909 may be in communication with a satellite-based system and may receive a location of computing device 900, as known in the art.

Computing device 900 may include other output device 905 (or corresponding interface circuitry, as discussed above). Examples of the other output device 905 may include an audio codec, a video codec, a printer, a wired or wireless transmitter for providing information to other devices, or an additional storage device.

Computing device 900 may include other input device 911 (or corresponding interface circuitry, as discussed above). Examples of the other input device 911 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 900 may include a security interface device 912. Security interface device 912 may include any device that provides security measures for computing device 900 such as intrusion detection, biometric validation, security encode or decode, access list management, malware detection, or spyware detection.

Computing device 900, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1-9. The subject matter may be applied to other deposition applications, as well as any appropriate manufacturing application, as will be understood to those skilled in the art.

The following examples pertain to further embodiments, and specifics in the examples may be used anywhere in one or more embodiments.

In one or more first embodiments, an apparatus includes a first stack of transistor channel regions separated by a first distance from each of an adjacent second stack of transistor channel regions and an adjacent third stack of transistor channel regions, a first source or drain material body spanning the first distance between the first and second stacks of transistor channel regions, wherein the first source or drain material body is coupled with both of the first and second stacks of transistor channel regions, a pair of second source or drain material bodies within the first distance between the first and third stacks of transistor channel regions, wherein a first of the pair of second source or drain material bodies is coupled with the first stack of transistor channel regions and a second of the pair of second source or drain material bodies is coupled to the third stack of transistor channel regions, and a dielectric material within the first distance and between the pair of second source or drain material bodies.

In one or more second embodiments, further to the first embodiments, also including a first metallization structure in contact with the first source or drain material body, a second metallization structure in contact with the first of the pair of second source or drain material bodies, and a third metallization structure in contact with the second of the pair of second source or drain material bodies, wherein the first and third metallization structures are on a first side of the stacks of transistor channel regions and the second metallization structure is on a second side of the stacks of transistor channel regions, opposite the first side.

In one or more third embodiments, further to the first or second embodiments, the second of the pair of second source or drain material bodies includes a first interface layer in contact with the third metallization structure and including silicon and a first metal, and a second interface layer in contact with the dielectric material and including silicon and the first metal or a second metal.

In one or more fourth embodiments, further to the first through third embodiments, the first and third stacks of transistor channel regions, the dielectric material, and the first and the second of the pair of second source or drain material bodies are contiguous, the dielectric material is in contact with and separates the first and the second of the pair of second source or drain material bodies, and the dielectric material extends at least a height of the pair of second source or drain material bodies between the first and the second of the pair of second source or drain material bodies.

In one or more fifth embodiments, further to the first through fourth embodiments, a void is between first and second layers of the dielectric material, the first layer is between the void and the first of the pair of second source or drain material bodies, and the second layer is between the void and the second of the pair of second source or drain material bodies.

In one or more sixth embodiments, further to the first through fifth embodiments, the first of the pair of second source or drain material bodies includes a first width, the second of the pair of second source or drain material bodies includes a second width, the dielectric material includes a thickness within the first distance and between the pair of second source or drain material bodies, and a sum of the thickness and the first and second widths is approximately equal to the first distance.

In one or more seventh embodiments, further to the first through sixth embodiments, a first dielectric plug includes the dielectric material and the thickness, the pair of second source or drain material bodies is a first pair of second source or drain material bodies, and also including a second pair of second source or drain material bodies, wherein a first of the second pair of second source or drain material bodies is coupled to the first source or drain material body by the second stack of transistor channel regions, and the first of the second pair of second source or drain material bodies is between the second stack of transistor channel regions and a second dielectric plug, a fourth stack of transistor channel regions, a third source or drain material body, and a third pair of second source or drain material bodies, wherein the fourth stack of transistor channel regions is coupled to and between the third source or drain material body and a first of the third pair of second source or drain material bodies, the first of the third pair of second source or drain material bodies is between the fourth stack of transistor channel regions and a third dielectric plug, and the third source or drain material body is coupled to the first source or drain material body, and a fifth stack of transistor channel regions and a fourth pair of second source or drain material bodies, wherein the fifth stack of transistor channel regions is coupled to and between the third source or drain material body and a first of the fourth pair of second source or drain material bodies, the first of the fourth pair of second source or drain material bodies is between the fifth stack of transistor channel regions and a fourth dielectric plug.

In one or more eighth embodiments, further to the first through seventh embodiments, the first of the second pair, the first of the third pair, and the first of the fourth pair of second source or drain material bodies include the first width, the second, third, and fourth dielectric plugs include the thickness, and the third source or drain material body spans the first distance between the fourth and fifth stacks of transistor channel regions.

In one or more ninth embodiments, further to the first through eighth embodiments, a dielectric plug includes the dielectric material within the first distance and between the pair of second source or drain material bodies, the first of the pair of second source or drain material bodies is symmetrical with the second of the pair of second source or drain material bodies, and the first and second of the pair of second source or drain material bodies are symmetrical about a vertical centerline of the dielectric plug.

In one or more tenth embodiments, further to the first through ninth embodiments, the first and second of the pair of second source or drain material bodies include first faces on the dielectric plug, the first and second of the pair of second source or drain material bodies include second faces opposite the dielectric plug, the pair of second source or drain material bodies between the second faces, and the second faces have a first height greater than a second height of the first faces.

In one or more eleventh embodiments, further to the first through tenth embodiments, the first source or drain material body is in a first trench, the first trench including a first width equal to the first distance, the pair of second source or drain material bodies is in a second trench with the dielectric material between the pair of second source or drain material bodies, the second trench including a second width equal to the first distance, and the first stack of transistor channel regions is in contact with the first source or drain material body and the first of the pair of second source or drain material bodies.

In one or more twelfth embodiments, an apparatus includes a trench between adjacent first and second transistor channel regions, wherein the trench includes a first width, and the first and second transistor channel regions are separated by the first width, a first source or drain material body in the trench, wherein the first source or drain material body is coupled with the first transistor channel region, and the first source or drain material body includes a second width, a second source or drain material body in the trench, wherein the second source or drain material body is coupled with the second transistor channel region, and the second source or drain material body includes the second width, and a dielectric isolation in the trench and between the first and second source or drain material bodies, wherein the dielectric isolation includes a third width, and the first width is approximately equal to a sum of the third width and twice the second width.

In one or more thirteenth embodiments, further to the twelfth embodiments, the first source or drain material body includes a layer in contact with the dielectric isolation, the layer including silicon and a metal.

In one or more fourteenth embodiments, further to the twelfth or thirteenth embodiments, the dielectric isolation includes first and second layers of a dielectric material, the dielectric isolation includes a void between the first and second layers of the dielectric material, the first layer is between the void and the first source or drain material body, and the second layer is between the void and the second source or drain material body.

In one or more fifteenth embodiments, further to the twelfth through fourteenth embodiments, the trench is a first trench, the first source or drain material body is coupled to a third source or drain material body by the first transistor channel region, the first and third source or drain material bodies are in contact with the first transistor channel region, the third source or drain material body is in a second trench between the first transistor channel region and a third transistor channel region, and the third source or drain material body includes the first width.

In one or more sixteenth embodiments, a method includes bisecting a semiconductor structure into first and second portions, wherein the first portion is coupled to a first channel region, and the second portion is coupled to a second channel region, and forming a dielectric layer adjacent and between the first and second portions.

In one or more seventeenth embodiments, further to the sixteenth embodiments, also including conformally depositing a mask layer over the semiconductor structure, wherein bisecting the semiconductor structure into the first and second portions includes etching between first and second sidewalls of the conformally deposited mask layer.

In one or more eighteenth embodiments, further to the sixteenth or seventeenth embodiments, also including metallizing an interface layer on or between the first portion and the dielectric layer, wherein bisecting the semiconductor structure into the first and second portions includes etching an opening between the first and second portions, metallizing the interface layer on or between the first portion and the dielectric layer includes depositing a metal in the opening, the interface layer includes silicon and the metal, and forming the dielectric layer adjacent and between the first and second portions includes depositing a dielectric material on the interface layer.

In one or more nineteenth embodiments, further to the sixteenth through eighteenth embodiments, also including forming a first metallization structure in contact with the first portion of the semiconductor structure, the first metallization structure on a first side of the first and second channel regions, and forming a second metallization structure in contact with the second portion of the semiconductor structure, the second metallization structure on a second side of the first and second channel regions, opposite the first side.

In one or more twentieth embodiments, further to the sixteenth through nineteenth embodiments, forming the dielectric layer adjacent and between the first and second portions includes depositing a dielectric material on the first portion, between the first and second portions, depositing the dielectric material on the second portion, between the first and second portions, and the dielectric material is between a void and the first portion and between the void and the second portion.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

1. An apparatus, comprising:
a first stack of transistor channel regions separated by a first distance from each of an adjacent second stack of transistor channel regions and an adjacent third stack of transistor channel regions;
a first source or drain material body spanning the first distance between the first and second stacks of transistor channel regions, wherein the first source or drain material body is coupled with both of the first and second stacks of transistor channel regions;
a pair of second source or drain material bodies within the first distance between the first and third stacks of transistor channel regions, wherein a first of the pair of second source or drain material bodies is coupled with the first stack of transistor channel regions and a second of the pair of second source or drain material bodies is coupled to the third stack of transistor channel regions; and
a dielectric material within the first distance and between the pair of second source or drain material bodies.

2. The apparatus of claim 1, further comprising:
a first metallization structure in contact with the first source or drain material body;
a second metallization structure in contact with the first of the pair of second source or drain material bodies; and
a third metallization structure in contact with the second of the pair of second source or drain material bodies, wherein the first and third metallization structures are on a first side of the first, second, and third stacks of transistor channel regions and the second metallization structure is on a second side of the first, second, and third stacks of transistor channel regions, opposite the first side.

3. The apparatus of claim 1, further comprising:
a first metallization structure in contact with the first source or drain material body;
a second metallization structure in contact with the first of the pair of second source or drain material bodies; and
a third metallization structure in contact with the second of the pair of second source or drain material bodies, wherein the second of the pair of second source or drain material bodies comprises:
a first interface layer in contact with the third metallization structure and comprising silicon and a first metal; and
a second interface layer in contact with the dielectric material and comprising silicon and the first metal or a second metal.

4. The apparatus of any one of claims 1-3, wherein:
the first and third stacks of transistor channel regions, the dielectric material, and the first and the second of the pair of second source or drain material bodies are contiguous;
the dielectric material is in contact with and separates the first and the second of the pair of second source or drain material bodies; and
the dielectric material extends at least a height of the pair of second source or drain material bodies between the first and the second of the pair of second source or drain material bodies.

5. The apparatus of any one of claims 1-4, wherein:
a void is between first and second layers of the dielectric material;
the first layer is between the void and the first of the pair of second source or drain material bodies; and
the second layer is between the void and the second of the pair of second source or drain material bodies.

6. The apparatus of any one of claims 1-5, wherein:
the first of the pair of second source or drain material bodies comprises a first width;
the second of the pair of second source or drain material bodies comprises a second width;
the dielectric material comprises a thickness within the first distance and between the pair of second source or drain material bodies; and
a sum of the thickness and the first and second widths is approximately equal to the first distance.

7. The apparatus of claim 6, wherein a first dielectric plug comprises the dielectric material and the thickness, the pair of second source or drain material bodies is a first pair of second source or drain material bodies, and further comprising:
a second pair of second source or drain material bodies, wherein a first of the second pair of second source or drain material bodies is coupled to the first source or drain material body by the second stack of transistor channel regions, and the first of the second pair of second source or drain material bodies is between the second stack of transistor channel regions and a second dielectric plug;
a fourth stack of transistor channel regions, a third source or drain material body, and a third pair of second source or drain material bodies, wherein the fourth stack of transistor channel regions is coupled to and between the third source or drain material body and a first of the third pair of second source or drain material bodies, the first of the third pair of second source or drain material bodies is between the fourth stack of transistor channel regions and a third dielectric plug, and the third source or drain material body is coupled to the first source or drain material body; and
a fifth stack of transistor channel regions and a fourth pair of second source or drain material bodies, wherein the fifth stack of transistor channel regions is coupled to and between the third source or drain material body and a first of the fourth pair of second source or drain material bodies, the first of the fourth pair of second source or drain material bodies is between the fifth stack of transistor channel regions and a fourth dielectric plug.

8. The apparatus of claim 7, wherein:
the first of the second pair, the first of the third pair, and the first of the fourth pair of second source or drain material bodies comprise the first width;
the second, third, and fourth dielectric plugs comprise the thickness; and
the third source or drain material body spans the first distance between the fourth and fifth stacks of transistor channel regions.

9. The apparatus of any one of claims 1-8, wherein:
a dielectric plug comprises the dielectric material within the first distance and between the pair of second source or drain material bodies;
the first of the pair of second source or drain material bodies is symmetrical with the second of the pair of second source or drain material bodies about a vertical centerline of the dielectric plug;
the first and second of the pair of second source or drain material bodies comprise first faces on the dielectric plug;
the first and second of the pair of second source or drain material bodies comprise second faces opposite the dielectric plug, the pair of second source or drain material bodies between the second faces; and
the second faces have a first height greater than a second height of the first faces.

10. The apparatus of any one of claims 1-9, wherein
the first source or drain material body is in a first trench, the first trench comprising a third width
equal to the first distance;
the pair of second source or drain material bodies is in a second trench with the dielectric
material between the pair of second source or drain material bodies, the second trench comprising a fourth width equal to the first distance; and
the first stack of transistor channel regions is in contact with the first source or drain material
body and the first of the pair of second source or drain material bodies.

11. A method, comprising:
bisecting a semiconductor structure into first and second portions, wherein the first portion is coupled to a first channel region, and the second portion is coupled to a second channel region; and
forming a dielectric layer adjacent and between the first and second portions.

12. The method of claim 11, further comprising conformally depositing a mask layer over the semiconductor structure, wherein bisecting the semiconductor structure into the first and second portions comprises etching between first and second sidewalls of the conformally deposited mask layer.

13. The method of either claim 11 or 12, further comprising:
metallizing an interface layer on or between the first portion and the dielectric layer, wherein:
bisecting the semiconductor structure into the first and second portions comprises etching an opening between the first and second portions;
metallizing the interface layer on or between the first portion and the dielectric layer comprises depositing a metal in the opening; and
the interface layer comprises silicon and the metal.

14. The method of any one of claims 11-13, further comprising:
forming a first metallization structure in contact with the first portion of the semiconductor structure, the first metallization structure on a first side of the first and second channel regions; and
forming a second metallization structure in contact with the second portion of the semiconductor structure, the second metallization structure on a second side of the first and second channel regions, opposite the first side.

15. The method of any one of claims 11-14, wherein forming the dielectric layer adjacent and between the first and second portions comprises:
depositing a dielectric material on the first portion, between the first and second portions;
depositing the dielectric material on the second portion, between the first and second portions; and
the dielectric material is between a void and the first portion and between the void and the second portion.
